# EUROPÄISCHE PATENTSCHRIFT

(11) **EP 4 413 545 B1**
(45) Veröffentlichungstag und Bekanntmachung des Hinweises auf die Patenterteilung: **26.08.2026**
(21) Anmeldenummer: 22818202.8
(22) Anmeldetag: 01.10.2022
(51) Int. Cl.: G06V 20/10, G06V 20/64

(54) **STRUKTURERFASSUNG ZUR OPTIMIERUNG VON RESSOURCENNUTZUNGEN IN PHYSIKALISCHEN SYSTEMEN**
STRUCTURE DETECTION FOR THE OPTIMIZATION OF RESOURCE UTILIZATION IN PHYSICAL SYSTEMS
DÉTECTION DES STRUCTURES POUR OPTIMISER L'UTILISATION DES RESSOURCES DANS LES SYSTÈMES PHYSIQUES

(30) Priorität: 04.10.2021 LU 102861
(43) Veröffentlichungstag der Anmeldung: 14.08.2024
(73) Patentinhaber: SYTE GMBH, 48149 Münster (DE)
(72) Erfinder: NELLESSEN, David, 48155 Münster (DE); ZÜHLKE, Matthias, 48151 Münster (DE); KÖNNING, Sven, 48151 Münster (DE)
(74) Vertreter: Rössler, Thomas
(86) Internationale Anmeldenummer: PCT/EP2022/077421
(87) Internationale Veröffentlichungsnummer: WO 2023/057362

(56) Entgegenhaltungen:
- EP-A1- 3 376 160
- US-B1- 8 620 089
- PARK YUJIN ET AL: "Creating 3D city models with building footprints and LIDAR point cloud classification: A machine learning approach", COMPUTERS ENVIRONMENT AND URBAN SYSTEMS, vol. 75, 28 January 2019 (2019-01-28), pages 76 - 89, XP085623104, ISSN: 0198-9715, DOI: 10.1016/J.COMPENVURBSYS.2019.01.004
- JIANN-YEOU RAU ET AL: "Automatic roof model reconstruction from ALS data and 2D ground plans based on side projection and the TMR algorithm", ISPRS JOURNAL OF PHOTOGRAMMETRY AND REMOTE SENSING, vol. 66, no. 6, 4 October 2011 (2011-10-04), pages S13 - S27, XP028346805, ISSN: 0924-2716, [retrieved on 20110910], DOI: 10.1016/J.ISPRSJPRS.2011.09.001

## Beschreibung

### Gebiet der Erfindung

Die vorliegende Erfindung bezieht sich im Allgemeinen auf das Gebiet der physikalischen Systeme und deren Optimierung und optimaler Nutzung. Viele physikalische Systeme können durch Beschreibungen beschrieben werden, welche beispielsweise auf einem zwei-, drei- oder sogar höherdimensionalen Raum existieren.

Es ist für den Fortschritt und die Verbesserung der physikalischen Systeme häufig erstrebenswert, Verbesserungspotentiale der Systeme souverän zu erkennen, ihre Zulässigkeit zu beurteilen und die vorgeschlagenen Verbesserungen in die Realität umzusetzen.

In einem Ausführungsbeispiel kann die Bebauung oder Nutzung von Flächen in einem physikalischen System optimiert werden, was zu einer verbesserten Flächen- und Volumennutzung im System führt.

Erfindungsgemäß kann ein Bodenreferenzpunkt genauer bestimmt werden, was die Verfahrensgenauigkeit erhöht.

### Technischer Hintergrund

Vorgaben für die physikalischen Systeme, z.B. Gesetze wie Naturgesetze, aber auch künstliche oder menschengemachte Gesetze (z.B. gesetzliche Vorschriften des Bauplanungsrechtes), können die möglichen oder zulässigen Modifikationen für die physikalischen Systeme möglicherweise einschränken. Ein weiteres Beispiel ist durch Vorschriften einer Qualitätssicherung gegeben, welche beispielsweise Qualitäts- und/oder Homogenitätsanforderungen an ein elektronisches oder mechanisches Bauteil definieren.

Verschiedene aus dem Stand der Technik bekannte Techniken werden im Folgenden kurz umrissen werden.

Aus dem Stand der Technik sind insbesondere Katasterdaten bekannt. Solche Daten sind, zudem häufig bruchteilhaft und auf bestimmte geographische Regionen spezialisiert, abrufbar über elektronische Systeme. Ein Beispiel hierfür ist durch ein Amtliches Liegenschaftskatasterinformationssystem (ALKIS) gegeben.

Solche Daten werden in der Regel von Vermessungstechnikern oder öffentlich bestellten Vermessungsingenieuren gemessen, welche vor Ort entsprechende geodätische Messungen unter Nutzung entsprechender mobiler Messapparaturen praktizieren, welche an den zu vermessenden Ort geschafft, dort eingestellt und sukzessive genutzt werden können.

Die Daten sind zudem in der Regel, insbesondere im Hinblick auf die tatsächlich vorliegende komplexe Struktur, auf sehr stark vereinfachte Messgrößen beschränkt und geben daher nur äußerst grobe Einsichten in die tatsächlichen Gegebenheiten. Substrukturen wie individuelle Einzelheiten einzelner Gebäude werden häufig ignoriert. Im bekanntesten Falle werden von den Vermessungstechnikern oder öffentlich bestellten Vermessungsingenieuren lediglich Gebäudeumringe, in der Regel zudem nur in Form zweidimensionaler Daten, vermessen. Manchmal wird zudem eine Anzahl der Vollgeschosse eines Gebäudes angegeben, so wie sie durch den Vermessungstechniker oder öffentlich bestellten Vermessungsingenieur an der Gebäudestruktur abgelesen wurde.

Auch ist aus dem Stand der Technik eine Vorgehensweise bekannt, welche dem Grunde nach eine Vermessung der Erdoberfläche samt der sich hierauf befindlichen Objekte liefert. Eine beispielhafte Technik hierzu ist Light Detection and Ranging (LIDAR oder auch LiDAR). Beispielsweise kann eine LIDAR-Messung als rasterweises Laserscanning an Bord eines Flugzeuges ausgeführt werden, indem es die unter dem Flugzeug befindlichen Strukturen vermisst. Diese Daten gehen jedoch häufig nicht über Daten in Form von räumlichen Punktdaten ("Punktwolken") hinaus. Dies ist unter anderem darin bedingt, dass LIDAR im Wesentlichen auf Abstandsmessungen basiert. Insbesondere schafft LIDAR als solches lediglich Punktwolken ohne Interpretation, was eine weitergehende gewinn- und erkenntnisbringende Analyse von LIDAR-Daten nachhaltig erschwert.

Zudem sind Punktwolken häufig von einzelnen Messfehlern (z.B. "Ausreißern") befallen, was selbst bei eingehendem Studium der Punktwolkendaten zu falschen Rückschlüssen führen kann. Dies führt insbesondere bei automatisierter Datenverarbeitung zu massiven Folgefehlern.

Eine andere Technik aus einem anderen technischen Bereich ist durch Künstliche Neuronale Netze bzw. Artifical Neural Networks (ANN) gegeben. Beispielsweise ist bekannt, dass der Übersetzungsdienstleister DeepL derartige Netzwerke benutzt, um mit hoher Informationsgenauigkeit Texte von einer natürlichen Sprache in eine andere natürliche Sprache zu überführen. Dies ist unter anderem aufgrund von umfangreichen Datenbanken, wie der Linguee-Datenbank, möglich, welche ein entsprechendes Training des bzw. der ANN ermöglichen. Das bzw. die ANN sind präzise, allerdings nur zu dem genannten Zweck.

Der Stand der Technik bringt den Nachteil mit sich, dass enorme Datenpotentiale ungenutzt bleiben. Durch die Fragmentierung der Daten und Datenquellen und unterschiedliche Formate wird eine Einsicht in potenzielle Änderungs- und Verbesserungsmöglichkeiten abermals erschwert.

In anderen physikalischen Systemen wie beispielsweise der Festkörperphysik (z.B. zweidimensionale Elektronengase) und bei Quantencomputern gibt es ähnliche Probleme.

Das Dokument EP 3 376 160 A1 offenbart ein Verfahren und System zur Datenverarbeitung. Das technische Ergebnis ist die Verbesserung der Genauigkeit der Bestimmung von städtischen Objekten bei der Erstellung von städtischen Panoramamodellen auf der Grundlage von Laserscannerdaten und fotografischen Daten. Erklärtes Ziel ist die computerrealisierbare Erkennung städtischer Objekte. Sie besteht in der Verarbeitung von Primärdaten, die zumindest fotografische Daten und Laserscanning-Daten enthalten, einschließlich Informationen über städtische Standorte, und umfasst die folgenden Schritte - Bereinigung und Überprüfung der erhaltenen Primärdaten, die städtische Einrichtungen enthalten; - Vorverarbeitung der bereinigten Laserscanning-Daten, in denen: - Konstruktion der Normalen für jeden Punkt der Wolke; - Konstruktion von Ebenen für Punktwolken; - Erstellung von Reliefs des Geländes und einzelner Objekte (z. B. Gebäudefassaden) mit Hilfe photogrammetrischer Algorithmen auf der Grundlage von Fotos, die von verschiedenen Punkten im Raum aufgenommen wurden.

Der vorliegenden Erfindung liegt daher die technische Aufgabe zugrunde, Verfahren bereitzustellen, die die Nachteile des Standes der Technik überwinden und neue Lösungen ermöglichen. Insbesondere soll ein Verfahren zur Optimierung und Erkennung von Verbesserungspotentialen in physikalischen Systemen, insbesondere möglichst generischen physikalischen Systemen, geschaffen werden. Beispielhafte Anwendungen der Erfindungen sind im Immobiliensektor, im Logistiksektor, der Steuer- und Regelungstechnik, integrierten Schaltkreisen und Quantencomputern denkbar.

Es sollen hierzu flexiblere, skalierbare, übertragbare, sicherere, verlässlichere Lösungen geschaffen werden. Auch der Faktor der Kostenminimierung spielt eine wesentliche Rolle. Die Verfahren sollen dabei auf technischen Systemdaten, insbesondere auch gemessener "raw data" operieren können. Die Verfahren sollen ferner nicht nur potentielle Optimierungen physikalischer Systeme, z.B. als Simulation, vorschlagen können, sondern Umsetzungen dieser Optimierungen in die Realität durch entsprechende Modifikation der physikalischen Systeme sind vorgesehen. Die generische feldübergreifende Anwendbarkeit, insbesondere auch für verschiedenartige physikalische Systeme verschiedener Natur, soll gewährleistet sein.

Die Nachteile des Standes der Technik werden überwunden durch das Verfahren nach Anspruch 1, den Computer, das Computerprogramm, das Computernetzwerk und den computerlesbaren Datenträger nach Anspruch 15.

### Beschreibung der Erfindung

Die vorliegende Erfindung ist im beigefügten Anspruchssatz beschrieben. Sie schafft ein Verfahren mit den Merkmalen des Anspruchs 1. Weitere vorteilhafte Ausgestaltungen sind in den Unteransprüchen angegeben.

Es ist ein Verfahren zur Optimierung von Volumen- und/oder Flächennutzungen in einem physikalischen System vorgesehen, umfassend die folgenden Schritte: Identifizieren eines physikalischen Systems in einem n-dimensionalen Raum, insbesondere dreidimensionalen Raum, Identifizieren eines (n-1)-dimensionalen Raumes, insbesondere zweidimensionalen Raumes, welcher zu einer Beschreibung einer (n-1)-dimensionalen Projektion des physikalischen Systems im n-dimensionalen Raum geeignet ist, Bereitstellen von n-dimensionalen Punktdaten, insbesondere LIDAR-Daten, und/oder 3D-Modellen in unterschiedlichen Detaillierungsgraden (LoD-Daten), welche insbesondere eine oder mehrere Oberflächen beschreiben, Bereitstellen von Sekundärdaten umfassend (n-1)-dimensionale Daten, insbesondere Polygondaten, insbesondere eines Katasters, welche insbesondere eine oder mehrere Ebenen beschreiben, Identifizieren eines oder mehrerer Teilsysteme in dem physikalischen System, insbesondere mittels der Sekundärdaten, insbesondere auch unter Zuordnung von Sekundärdaten zu den Teilsystemen, Bestimmen von Teilsystemdaten mindestens zweier Teilsysteme, welche Größen des jeweiligen Teilsystems beschreiben, insbesondere umfassend die Sekundärdaten des jeweiligen Teilsystems und die n-dimensionale Punktdaten und/oder LoD-Daten zum jeweiligen Teilsystem, ganz oder teilweise, Auswählen mindestens eines Teilsystems, Nutzen eines Machine-Learning-Modells eines überwachten Lernens, inbesondere eines trainierten Künstlichen Neuronalen Netzes und/oder einer linearen Regression, zum Vorhersagen von Eigenschaften des ausgewählten Teilsystems auf Basis der Sekundärdaten des ausgewählten Teilsystems und der Teilsystemdaten von anderen, nicht ausgewählten Teilsystemen.

Das Verfahren ist für generische physikalische Systeme anwendbar.

Physikalische Systeme sind generische physikalische Systeme zu deren Struktur und Beschaffenheit Messdaten, d.h. technische Daten, bereitgestellt werden können.

Aspekte der Erfindung werden teilweise im Rahmen einer beispielhaften Ausführungsform für eine Anwendung in der proaktiven nachhaltigen Städteplanung erläutert, ohne jedoch hierauf beschränkt zu sein.

So erfolgt ein Schritt eines Identifizierens eines physikalischen Systems in einem n-dimensionalen Raum. Dies kann insbesondere ein dreidimensionaler Raum sein. Es kann sich auch um einen Teil/Ausschnitt eines n-dimensionalen Raumes handeln. n ist eine natürliche Zahl. In einem zweidimensionalen Beispiel mit n=2 wird beispielsweise ein zweidimensionales Elektronengas beschrieben. Dessen Beschreibung kann beispielsweise klassisch oder auch quantenmechanisch erfolgen. In einem anderen Beispiel ist es ein Teil/Ausschnitt eines dreidimensionalen Raumes. In einem weiteren Beispiel umfasst dieser Raum bebaute Grundflächen bzw. Grundstücke. So können sich Gebäude, einschließlich ihrer Dächer, in diesem Raum befinden. Verschiedenste Größen bzw. Skalen für Systeme sind denkbar. Es könnte sich beispielsweise um Nachbarschaften, Dörfer, Städte, Länder, Kontinente oder auch um eine Weltkarte handeln. Auch anders limitierte Strukturen sind denkbar, wie beispielsweise Rasterquadrate oder die Summe verschiedener Liegenschaften, welche einheitlichen Bebauungsgesetzen oder Bebauungsplänen unterliegen.

Auch andere physikalische Systeme sind denkbar. Es sei betont, dass diese physikalischen Systeme keineswegs auf Beschreibungen in n=3 Dimensionen beschränkt sind. In einem dreidimensionalen Beispiel können beispielsweise verschiedene Boxen, oder andere Konstruktionen zur Warenaufnahme und deren -lagerung, in großen Lagerhallen oder dergleichen untergebracht sein. Auch dieses Beispiel ist gewöhnlich dreidimensional. Es gibt auch in diesem Bereich Optimierungsanforderungen, bei denen die vorliegende Erfindung zum Einsatz gebracht werden kann. Beispielsweise sollten nicht vereinzelte, sehr schwere Boxen (Boxen mit hohem Gewicht durch ihren Inhalt) hoch oben auf andere, sehr leichte Boxen gestellt werden. Leichte Boxen haben häufig einen leichten und zudem nicht sehr formfesten Inhalt, und sind dadurch eher gefährdet als schwere Boxen, durch andere schwere Boxen beschädigt bzw. "zerdrückt" oder jedenfalls "eingedrückt" zu werden.

Die Erfindung kann auf den verschiedensten Gebieten zur Anwendung gebracht werden. Besonders gewinnbringend ist der Einsatz der vorliegenden Erfindung auf solchen Gebieten, wo gewisse schwer greifbare und daher nicht unmittelbar und präzise erfassbare Anforderungen an individuelle Elemente gestellt werden, insbesondere Homogenitätsanforderungen der Elemente in Bezug auf die sie umgebenden Bereiche. Solche Anwendungen umfassen Anwendungen der Systemtechnik, integrierte Schaltkreise als auch Datenspeicher und Quantencomputer.

Es erfolgt ein Schritt eines Identifizierens eines (n-1)-dimensionalen Raumes, insbesondere zweidimensionalen Raumes, welcher zu einer Beschreibung einer (n-1)-dimensionalen Projektion des physikalischen Systems im n-dimensionalen Raum geeignet ist.

Beispielsweise ist dies eine zweidimensionale Fläche wie ein Stück Boden, wie es beispielsweise auf einer einfachen Landkarte dargestellt werden kann. Gebäude können in diesem Beispiel durch Projektion auf die zweidimensionale Karte gebracht werden. So haben Gebäude hier in der Regel einen zweidimensionalen Umriss. Bei dieser Projektion geht häufig Information verloren, insbesondere zur Höhe des Gebäudes, Form des Daches, uvm.

In einem Beispiel haben wir es so mit einer zweidimensionalen Projektion eines Gebäudes, einer Liegenschaft, einer Nachbarschaft, eines Dorfes, einer Stadt oder eines Landes zu tun. Es können auch mehrere davon in dem zweidimensionalen Bereich enthalten sein. In einem Beispiel ist dies die Stadt Münster, samt umliegender Stadtteile, oder es ist das Bundesland NRW, Deutschland oder Europa. Es kann sich aber auch nur um ein kleines Neubaugebiet oder das Gebiet eines Bauprojektes handeln.

Für den n- als auch den (n-1)-dimensionalen Raum können entsprechende Daten besorgt, z.B. auch aus einer oder mehreren Datenbanken abgerufen, werden. Insbesondere können diese Daten auch im Rahmen der Erfindung gemessen werden. Kombinierung von verschiedenen Datenquellen und Daten ist ebenso möglich. Beispielsweise können selbst gemessene mit in Datenbanken vorhandenen Daten gewinnbringend und fehlerreduzierend kombiniert werden.

In einem Beispiel können n-dimensionale Punktdaten zum Einsatz gebracht werden.

Für einen dreidimensionalen Raum mit verschiedenen Grundstücken und Gebäuden bieten sich so dreidimensionale Punktdaten an. Insbesondere LIDAR-Daten (Light Detection and Ranging) sind gut geeignet. So kann alternativ bzw. kombinativ auch im Rahmen der Erfindung eine LIDAR-Messung zum Einsatz kommen.

Bereits gemessene LIDAR-Punktdaten können beispielsweise in Deutschland von den Landesbehörden bezogen bzw. abgerufen werden. Ein beispielhaftes geeignetes Format für solche Daten ist LAS, es können aber auch andere Formate für Punktwolken zum Einsatz gebracht werden. In einem Beispiel sind die Daten komprimiert, z.B. LAZ, was technische Ressourcen, insbesondere bei der Übertragung und/oder dem Direktabruf spart. So kann zudem Zeit gespart werden und Ergebnisse können schneller zur Verfügung gestellt werden. Punktdaten können teilweise bestimmten Teilsystemen eines physikalischen Systems zugeordnet werden oder sein. Eine solche Zuordnung erfolgt aufgrund technischer Erwägungen und/oder Erkenntnis der technischen Struktur und Substruktur des physikalischen Systems. Verschiedene Varianten und Weiterbildungen werden hierzu an späterer Stelle genauer erläutert.

In einer erfindungsgemäßen Alternative kommen sogenannte LoD-Daten zum Einsatz. Level of Detail (LoD, Detaillierungsgrad) beschreibt 3D-Modelle, bei welchen Daten in verschiedenen Detaillierungsgrad-Stufen vorliegen. Dies hat den Vorteil, dass die Detaillierungsgradstufe für eine Berechnung frei wählbar ist und variabel bleibt. So kann für jeden Fall eine passende LoD-Stufe gewählt werden, der adäquate Berechnungen bzw. Darstellungen ermöglicht.

Es handelt sich um vereinfacht gesagt leicht handhabbare "Klötzchenmodelle", welche beispielsweise Gebäude adäquat beschreiben können. Dabei sind die Daten auf Wesentliches reduziert und liegen zudem in unterschiedlichem Detaillierungsgrad vor. Diese Modelle werden oft aus LiDAR-Daten generiert und weisen so in der Regel einen niedrigeren Genauigkeitsgrad auf als die LiDAR-Daten selbst.

LoD-modellbasierte Daten sind besonders leicht zu handhaben und führen zu kurzen Berechnungszeiten auf Anfragen, da diese durch die LoD-Modelle weniger rechenintensiv sind.

Als weitere Variante können LoD-Daten im Rahmen der Erfindung aus den LIDAR-Daten hergeleitet, d.h. erzeugt, werden. So ergibt sich ein weiterer Zwischenschritt. Im folgenden können dann Berechnungen auf Grundlage der originären LIDAR-Daten und/oder der hieraus abgeleiteten LoD-Daten erfolgen.

Es erfolgt ein Bereitstellen von Sekundärdaten umfassend (n-1)-dimensionale Daten, insbesondere Polygondaten, insbesondere eines Katasters. Dies sind also beispielsweise zweidimensionale Daten, beispielsweise aus einem Kataster. Solche Daten können beispielsweise von einem amtlichen Liegenschaftskatasterinformationssystem (ALKIS) bezogen werden. Beispielsweise können den ALKIS-Daten die Form und Lage von Grundstücken und/oder Flurstücken entnommen werden. Häufig sind auch nur Daten zu Flurstücken verfügbar, die Daten der Grundstücke können jedoch manchmal durch geschickte Rekombination der Flurstücke rekonstruiert werden. Alternativ kann diese Rekombination durch Angaben der Anwender geschehen. Im Rahmen der vorliegenden Anmeldung werden Grund- und Flurstücke im Wesentlichen als Synonyme betrachtet, wenn nicht gerade der Unterschied ausdrücklich hervorgehoben wird. In vielen Fällen entspricht zudem ein Grundstück einem Flurstück, d.h. das Grundstück umfasst lediglich ein Flurstück, wobei jedenfalls zu letzterem die ALKIS-Daten Auskunft geben. Auch Umrisse von Gebäuden können beispielsweise den ALKIS-Daten entnommen werden. Des Weiteren können zusätzliche Daten bzw. Metadaten (häufig z.B. Angaben zur Anzahl an Vollgeschossen oder zur Nutzung oder Nutzungsart) enthalten sein.

Auch Aussagen zu weiteren versiegelten Flächen können prinzipiell in einem solchen Datensatz enthalten sein und sodann diesem Datensatz entnommen werden. Dies ist jedoch in der Regel nicht der Fall, was jedoch durch verschiedene Weiterbildungen der vorliegenden Erfindung behoben werden kann. Dies wird an entsprechender Stelle diskutiert werden. Beispielsweise sind hier Terrassen und Parkplätze zu nennen.

Im Falle eines zweidimensionalen Elektronengases können die Sekundärdaten Skalare umfassen.

In einem Beispiel basieren die Daten oder ein Teil davon auf einer Normbasierten Austauschschnittstelle zum Austausch von Geoinformationen (NAS). Ein beispielhaftes Format ist das GML-Format (Geography Markup Language). Durch die Nutzung eines solchen standardisierten Formats wird die Interoperabilität mit vorhandenen Systemen und Lösungen erhöht.

Im Falle eines Systems, welches auf vier Dimensionen lebt (bspw. Minkowski-Raumzeit), umfassen die Sekundärdaten dreidimensionale Daten. Beispielsweise entsprechen diese Sekundärdaten dem räumlichen Teil eines raumzeitlichen Bezugssystems eines Beobachters.

Es erfolgt ein Identifizieren eines oder mehrerer Teilsysteme in dem physikalischen System, insbesondere mittels der Sekundärdaten. So kann im Rahmen einer Ausführungsform das System beispielsweise in Grundstücke zerlegt werden unter Zuhilfenahme der ALKIS-Daten. Die einem Grundstück samt Gebäude entsprechenden Sekundärdaten können so auch dem Teilsystem zugeordnet werden.

Sodann können Teilsystemdaten für Teilsysteme generiert werden. Solche Teilsystemdaten sind den Teilsystemen zugeordnet und können Größen des jeweiligen Teilsystems beschreiben. Solche Teilsystemdaten können die bereits erwähnten Sekundärdaten umfassen. Solche Teilsystemdaten können jedoch auch die entsprechenden n-dimensionalen Punkt- bzw. LIDAR-Daten, beispielsweise über dem Grundstück des Teilsystems (z.B. erhalten durch entsprechendes "Verschneiden" der Daten), oder Teile dieser LIDAR-Daten enthalten. Die Teilsystemdaten können zudem weitere abgeleitete Größen aus anderen Teilsystemdaten enthalten. Als Beispiel sei ein Bodenreferenzpunkt genannt. Ein weiteres Beispiel kann eine First- und/oder eine Traufhöhe sein. Die Teilsystemdaten können so im Rahmen der Erfindung beliebig durch weitere berechnete bzw. derivate Größen zum Teilsystem erweitert werden. Die Teilsystemdaten können zum Trainieren und Nutzen eines Künstlichen Neuronalen Netzes dienen. Dies wird an späterer Stelle ausführlicher erläutert.

Es können auch die Sekundärdaten mit den Punktdaten, z.B. den LIDAR-Punktdaten, verschnitten werden. Was damit gemeint ist, wird im Folgenden erläutert. Beispielsweise beschreiben Katasterdaten zweidimensionale Polygone für Flurstücke, Grundstücke und/oder Gebäude auf den Grundstücken (z.B. in Form der Umrisse der mit dem Gebäude bebauten Fläche). Um nun beispielsweise bestimmte Größen des Hauses möglichst genau aus den LIDAR-Daten zu bestimmen, können zum Beispiel LIDAR-Punkte ausgewählt werden, welche, wenn in die zweidimensionale Ebene projiziert, über dem Grundstück liegen ("Veschneiden" der Daten). Hierdurch wird die Genauigkeit der derivaten Messgrößen erhöht, da Fehlerquellen abgeschnitten und hierdurch vermieden werden können. Beispielsweise wird so ein Baum in der Nähe des Hauses nicht berücksichtigt, wenn beispielsweise First- und Traufhöhe des Daches bestimmt werden sollen.

In einem weiteren Beispiel erhöht sich hierdurch die Genauigkeit in rechtlicher Hinsicht. In vielen Gebieten kann eine Traufhöhe eines Daches baurechtlich so definiert sein, dass sie auch bei einem überstehenden Dach exakt am Rande des bebauten Grundstückes zu messen ist. Da durch das Verschneiden ein über den Rand des bebauten Grundstückes überstehendes Dach abgeschnitten wird, erhöht sich die Genauigkeit der Bestimmung der Größe, welche baurechtlich als besonders relevant eingestuft wird. Die relevanten, verschnittenen Punkte können datentechnisch besonders markiert werden, sodass sich eine erneute Bestimmung erübrigt. Diese Technik bietet sich bei sämtlichen "Verschnittvorgängen" im Rahmen der vorliegenden Erfindung und ihren Weiterbildungen an. Hierdurch wird Rechenzeit gespart, da die relevanten Datenpunkte durch die hieran angebrachten Flags unmittelbar für weitere Berechnungen zur Verfügung stehen.

Wichtige Eigenschaften, Messgrößen und derivate Eigenschaften sowie Maße der baurechtlichen Nutzung werden an späterer Stelle im Detail diskutiert werden. An dieser Stelle sei lediglich beispielhaft auf die First- und die Traufhöhe in Bezug auf das Dach eines Gebäudes verwiesen. Durch die kombinierte Nutzung von Kataster- und LIDAR-Daten ist eine genaue Bestimmung für beliebige Gebäude möglich. Kataster- und LIDAR-Daten sind nämlich mit guter Flächendeckung und Genauigkeit, teilweise kommerziell und teilweise sogar kostenfrei, verfügbar.

Das oben beschriebene Beispiel funktioniert besonders solide, wenn die Gebäudeumrissen, beispielsweise aus den ALKIS-Daten, sehr präzise bekannt sind. Das Verfahren ist daher beispielsweise das bevorzugte Verfahren der Wahl für Deutschland, in dem die Gebäudeumrisse im Rahmen der ALKIS-Daten sehr präzise vermessen wurden.

Es sei an dieser Stelle noch auf weitere alternative Vorgehensweisen im Rahmen der vorliegenden Erfindung verwiesen. Die Punktdaten können also, müssen jedoch nicht mit beispielsweise dem Gebäudeumriss verschnitten werden. Es können auch alle Punktdaten über dem gesamten Grundstück, jeweils adäquat, berücksichtigt werden. Es können sogar Punktdaten benachbarter Grundstücke einfließen.

In einem weiteren Beispiel wird ein spezielles, hierzu speziell trainiertes, Machine-Learning-Modell dazu eingesetzt, aus den Punktdaten möglichst präzise die Gebäude, Gebäudeumrisse und/oder derivate Größen wie beispielsweise die First- und/oder Traufhöhe etc. zu bestimmen. Diese Vorgehensweise ist besonders präzise und deckt auch "Ausreißerfälle" wie Besonderheiten nicht-konventioneller Gebäude, souverän ab. Beispielsweise kommt ein Künstliches Neuronales Netz als Machine-Learning-Modell zum Einsatz.

In einem Beispiel wird das Machine-Learning-Modell mit Daten aus Deutschland trainiert. In Deutschland sind die Gebäudeumrissdaten aus den ALKIS-Daten mit vergleichsweise recht hoher Präzision verfügbar. Sodann kann das trainierte Machine-Learning-Modell hervorragend auch in Regionen des Auslands zum Einsatz gebracht werden, wo die Gebäudeumrisse nicht so genau bekannt sind bzw. vermessen wurden, und daher nicht so präzise im Rahmen von Katasterdaten verfügbar sind. Hierdurch wird die Präzision nicht nur insgesamt erhöht, die Präzision kann insbesondere souverän mit dem Machine-Learning-Modell auf geographische Regionen ausgeweitet werden, in denen hinreichend präzise Daten nicht verfügbar sind.

Es können im Rahmen der vorliegenden Erfindung auch eigens speziell an den Zweck der vorliegenden Erfindung angepasste LIDAR-Messungen in gesonderter Form durchgeführt werden. So sind spezielle Anpassungen möglich wie beispielsweise eine höhere Raster-/Scanauflösung in Städten oder dicht besiedelten Gebieten.

Für die in einem passenden Beispiel zahlreichen Teilsysteme sollten Teilsystemdaten erzeugt werden. Beispielsweise sind dies die oben erwähnten wichtige Eigenschaften, Messgrößen und andere derivate Eigenschaften. Die Teilsystemdaten sollten technisch interessante und/oder beispielsweise in baurechtlicher Hinsicht relevante Daten zu den Teilsystemen enthalten. In einem anderen Beispiel zur Qualitätssicherung integrierter Schaltkreise können dies bestimmte technische Anforderungsdaten und -größen sein, welche ein Bauteil, welches den Qualitätssicherungsprozess bestehen soll, zu erfüllen hat.

Ein Teilsystem wird sodann ausgewählt. Es könnten auch mehrere sein, jedoch wird im Folgenden der Einfachheit halber der Fall eines einzelnen ausgewählten Teilsystems diskutiert werden.

Dieses Teilsystem soll nun auf Optimierbarkeit und/oder Bebaubarkeit/verbesserte Nutzbarkeit untersucht werden. Zu diesem Zwecke wird erfindungsgemäß ein speziell trainiertes Machine-Learning-Modell, insbesondere Künstliches Neuronales Netz(werk), zum Einsatz gebracht. Dies geschieht auf Basis der Sekundärdaten des ausgewählten Teilsystems einerseits und der Teilsystemdaten von insbesondere anderen, insbesondere nicht ausgewählten, Teilsystemen andererseits. Diese Daten können so beispielsweise den Input/die Eingangsgrößen darstellen, welcher an entsprechende Eingangsneuronen des Künstlichen Neuronalen Netzwerkes angelegt werden. Als Künstliche Neuronale Netze bieten sich insbesondere Tiefe Neuronale Netze (Deep Neural Networks) an, es können jedoch auch andere Techniken auf dem Gebiet der Künstlichen Intelligenz und des Maschinenlernens (Machine Learning) zum Einsatz gebracht werden.

Die Sekundärdaten des ausgewählten Teilsystems umfassen beispielsweise die Katasterdaten zum Grund- und/oder Flurstück. Es können auch Informationen zu Gebäuden enthalten sein. In einem Beispiel können auch hiervon abgeleitete Größen enthalten sein. Beispielsweise kann dies eine Grundfläche sein. In einem Beispiel umfassen die hier genannten Sekundärdaten eben nicht eventuelle Katasterdaten zu einem eventuell auf einem Grundstück vorhandenen Gebäude. Dies ist für eine Potentialanalyse für das Teilsystem besonders gewinnbringend, da Eigenschaften von Grundstücken nur schwerlich verändert, Eigenschaften der Gebäude jedoch bei Erkennung von Verbesserungspotential modifiziert werden können. Es ist also beispielsweise für eine Vorhersage von Eigenschaften von potentiell auf einem Grundstück errichtbaren Gebäuden von Vorteil, die Grundstückseigenschaften einfließen zu lassen, jedoch die Analyse nicht durch ein Einfließenlassen des "status quo", d.h. der derzeit vorhandenen Nutzung der Fläche durch bspw. Gebäude, zu verfälschen.

In einem Beispiel wird eine Fläche in einem Gebiet durch ein leerstehendes, verkommenes Gebäude besetzt (Extrembeispiel). Dieses Gebäude kann jedoch abgerissen, d.h. vom Grundstück entfernt werden, wenn dies erforderlich oder dem Fortschritt sachdienlich sein sollte, um Platz für Neues zu schaffen. Wenn das Machine-Learning-Modell, insbesondere das Künstliche Neuronale Netz, einen Vorschlag bzw. eine Vorhersage macht, welche beispielsweise einen hohen Nutzungsgrad, ggf. weitere vorteilhafte Kenngrößen, aufweist, kann es als durchaus sinnvoll und strukturverbessernd erachtet werden, den Vorschlag bzw. die Vorhersage in die Realität umzusetzen.

Die Teilsystemdaten anderer Teilsysteme, insbesondere nicht ausgewählter Teilsysteme, sind relevant für eine korrekte Erfassung von Vorgaben, insbesondere Umfeld- bzw. Umgebungsvorgaben, durch das Künstliche Neuronale Netz. Insbesondere erfasst das Künstliche Neuronale Netz durch diese Teilsystemdaten als Features/Einflussfaktoren beispielsweise verschiedene explizit anderweitig nur schwer zu erfassende Relevanzen und Anforderungen, beispielsweise insbesondere an Homogenitäten. Beispielsweise kann es baurechtliche Anforderungen an ein "homogenes Bild" geben, oder es muss sich in einem Beispiel ein neues Gebäude in seiner Bauhöhe den umliegenden Gebäuden - zumindest in ungefährer Hinsicht - anpassen.

In einem anderen Beispiel werden verschiedene Transistoren, als Teilsysteme, in einen integrierten Schaltkreis eingebracht. Bestimmte Kenngrößen, beispielsweise Spannungen uvm., können für ideal funktionsfähige Schaltkreise gewissen Homogenitätsanforderungen unterliegen.

Es sind zudem Quantencomputer in weitem Fortschritt der Entwicklung, welche mehrere Qubits umfassen. In vielen Beispielen wechselwirken diese Qubits sowohl untereinander durch Quantenverschränkung als auch mit externen Quellen wie Feldern. Es ist daher für einen ideal funktionsfähigen und maximal ausgenutzten Quantencomputer essentiell, dass die Qubits, welche hier die Teilsysteme darstellen oder in den Teilsystemen inkorporiert sind, insbesondere benachbarte Qubits, direkt benachbart oder auch entfernter benachbart, möglichst homogen ausgestaltet sind. Durch die Teilsystemdaten der umgebenden Qubits bei der Vorhersage eines ausgewählten Qubits kann dieser technische Effekt erfindungsgemäß erreicht werden.

Das Feature Engineering und das damit verbundene Festlegen der - potentiell - relevanten Merkmale, mit welchen das Künstliche Neuronale Netz arbeitet, haben einen hohen Einfluss auf die Qualität der erzielten Ergebnisse. Im Rahmen von Weiterbildungen der vorliegenden Erfindung werden entsprechende Aspekte ausführlich diskutiert werden.

In vielen Anwendungsfällen der Erfindung ist es so, dass Sekundärdaten Merkmale umfassen, welche nur schwerlich zu verändernde Umgebungs- und/oder Raumfaktoren beschreiben. Häufig sind dies durch äußere Umstände festgelegte oder fixe Faktoren. Es können weitere Faktoren einfließen, welche in zulässiger Näherung als stark homogen betrachtet werden können, z.B. eine Temperatur, ein Luftdruck oder eine Luftfeuchtigkeit. In vielen Fällen ist es zudem so, dass die Sekundärdaten eben keine Merkmale umfassen, welche als Veränderliche im Rahmen der Analyse von Verbesserungspotentialen behandelt werden. Der Ausschluss dieser Merkmale hat den Vorteil, dass diese präziser und ohne Einfluss von Störfaktoren durch das Künstliche Neuronale Netz vorhergesagt werden können.

In vielen Anwendungsfällen der Erfindung ist es zudem so, dass Teilsystemdaten durchaus Merkmale umfassen, welche als Veränderliche im Rahmen der Analyse von Verbesserungspotentialen behandelt werden. Die Berücksichtigung dieser Merkmale im Rahmen der Teilsystemdaten hat den Vorteil, dass diese eine präzise Vorhersage dieser oder ähnlicher Merkmale durch das Künstliche Neuronale Netz für das ausgewählte Teilsystem ermöglichen.

Die Erfindung kombiniert insbesondere Sekundärdaten des ausgewählten Teilsystems oder der ausgewählten Teilsysteme mit Teilsystemdaten von Teilsystemen. Insbesondere kombiniert die Erfindung Sekundärdaten des ausgewählten Teilsystems oder der ausgewählten Teilsysteme mit Teilsystemdaten von anderen Teilsystemen, welche eben nicht ausgewählt sind. Durch diese bewusste Wahl für das Feature Engineering können die genauen und verlässlichen Ergebnisse erzielt werden, welche Verbesserungspotentiale für das System erkennen und ihre Umsetzung ermöglichen.

Die Kombination der entsprechenden genannten Systemdaten erschließt somit neue, bisher unberührte Potentiale zur Systemverbesserung, unter Wahrung externer Anforderungen an Systeme, insbesondere lokale oder semilokale Homogenitätserfordernisse.

Das Machine-Learning-Modell selbst liefert eine verlustbehaftete Kompression der Eingangs- und Trainingsdaten.

Gemäß einer Weiterbildung wird und/oder wurde das Machine-Learning-Modell bzw. das Künstliche Neuronale Netz unter Nutzung einer selektierten Teilmenge vorhandener Teilsysteme trainiert, insbesondere mittels eines überwachten Lernens des Künstlichen Neuronalen Netzes.

In einem Beispiel geschieht diese Auswahl manuell/händisch, beispielsweise durch einen Mitarbeiter oder Nutzer. Beispielsweise werden bzw. wurden hierzu entsprechende

Teilsysteme, z.B. auch in einer bestimmten Region, ausgewählt, welche bereits bestimmte hohe Maße der baulichen Nutzung aufweisen (und damit gute Beispiele für eine effiziente Flächen- und Volumennutzung sind). In dem Beispiel sind derartige Zustände erstrebenswert. Daher sollten solche erstrebenswerten bzw. fortschrittlichen Fälle von Teilsystemen bevorzugterweise selektiert werden. Durch das Training des Künstlichen Neuronalen Netzes durch überwachtes Lernen mit diesen selektierten Teilsystemen orientieren sich die Vorschläge/Voraussagen des Netzes ebenfalls tendenziell an einer hohen baulichen Nutzung. Dadurch sind die Vorschläge besonders gut für Verbesserungen des physikalischen Systems zu gebrauchen, und das Netz konvergiert schneller auf brauchbare Lösungen. Unnötiges Training des Netzes sowie "falsches" oder unbrauchbares Training werden vermieden. Durch diese Vorauswahl bekommt das Gesamtsystem ein zusätzliches "Offset" bzw. einen "Drive", welches die Dynamik in Richtung kontinuierlicher Verbesserung umsetzt. Ein schlichtes Ersetzen von Teilsystemen durch sehr ähnliche Teilsysteme ohne signifikante Verbesserung wird hierdurch vermieden.

Gemäß einer Weiterbildung sind insbesondere Teilsysteme selektiert, welche in den Sekundär- und/oder Teilsystemdaten eine hohe Nutzung, insbesondere Volumen- und Flächennutzung, aufweisen, insbesondere charakterisiert durch ein Über- und/oder Unterschreiten von Schwellenwerten in Bezug auf die Sekundär- und/oder Teilsystemdaten.

Derartige Schwellenwerte sind eine leicht und günstig zu implementierende Variante für den "Drive", welcher die gewünschte zeitlich-dynamische Systementwicklung hervorruft. Es kann sich um absolute Schwellenwerte oder auch um relative Schwellenwerte handeln. Ein relativer Schwellenwert kann beispielsweise relativ in Bezug auf einen Mittelwert wie ein arithmetisches Mittel oder einen Median definiert sein.

Es können auch komplexere Systeme wie Entscheidungsbäume zur Abgrenzung der relevanten Teilsysteme und deren Selektion eingesetzt werden.

Gemäß einer Weiterbildung umfasst das Verfahren ferner einen Schritt eines Bereitstellens von Photogrammetriedaten, welche sich auf den n- und/oder (n-1)-dimensionalen Raum beziehen, sowie eines Ableitens mindestens einer Größe aus den Photogrammetriedaten, insbesondere in Kombination mit den Sekundärdaten und/oder Teilsystemdaten.

Durch die Hinzunahme der Photogrammetriedaten sind insbesondere noch präzisere Bestimmungen über die tatsächlichen Gegebenheiten eines Teilsystems, insbesondere auf Grundlage von LIDAR-Punktwolkendaten, möglich.

Für verschiedene Maße der baulichen Nutzung, beispielsweise First- und Traufhöhe eines Daches, kann eine präzise Bestimmung eines Bodenreferenzpunktes für das Teilsystem (beispielsweise eine "Höhe über Null") erforderlich bzw. sachdienlich sein. In einer einfachen Ausführungsform werden beispielsweise Katasterdaten, welche ein Grundstück und ein oder mehrere darauf befindliche Gebäude aufweisen, mit LIDAR-Daten verschnitten. Beispielsweise kann dann ein Bodenreferenzpunkt bestimmt werden, indem ein Mittelwert über die nicht im Bereich des Gebäudes befindlichen Referenzpunkte gebildet wird. Alternativ kann auch auf eine vorhandene Vorklassifikation in den LIDAR-Daten zurückgegriffen werden, z.B. aus Basis aller Punkte mit einem Flag "Ground" in den LIDAR-Daten. Es hat sich jedoch gezeigt, dass eine besonders präzise Bestimmung erst durch die Kombination mit der Photogrammetrie erreicht wird. Auf Basis der Photogrammetrie und entsprechender Selektion und Verarbeitung der LIDAR-Punkte wird so eine höhere Präzision erreicht als mit anderen Methoden zur Bestimmung des Bodenreferenzpunktes.

Auch die Bestimmung anderer Referenzpunkte, Referenzgrößen, derivaten Größen und Maßen der baulichen Nutzung kann durch die Zuhilfenahme der Photogrammetriedaten bewerkstelligt werden. Beispielsweise kann auch eine Größe oder ein tatsächlicher Anteil versiegelter Flächen an den Gesamtflächen genauer bestimmt werden, oder es sind weitere strukturelle Aussagen über die Beschaffenheit, Nutzung, Nutzungsart, uvm. des Teilsystems oder Teilen davon möglich. Entsprechende weitergehende Klassifikation von Teilsystemen aufgrund so bestimmter Merkmale von Teilsystemen wird ermöglicht. Auch auf eine Berechnung komplexer Größen kann sich der Einsatz von Photogrammetriedaten auswirken. In einem Beispiel kann erkannt werden, ob ein Dachgeschoss ausgebaut bzw. genutzt ist, oder nicht.

Auch bei anderen Systemtypen erweist sich die Kombination der Daten mit Photogrammetriedaten als sehr vorteilhaft. Auch bei beispielsweise Mikro- und Nanoelektronik ergeben sich so weitere gewinnbringende Erkenntnisse über die vorliegenden Strukturen, insbesondere in kombinativer, synergetischer Auswertung zusammen mit den übrigen, bereits erwähnten Daten.

Gemäß der vorliegenden Erfindung umfasst das Verfahren ferner einen Schritt eines Erkennens mindestens einer versiegelten Fläche und ihrer Abmaße auf Basis der Photogrammetriedaten. Durch das Erkennen und die sukzessive Berücksichtigung von bereits vorhandenen versiegelten Flächen wird das Ergebnis abermals präzisiert. Bei baurechtlichen Vorgaben und Bebauungsplänen ist häufig ein Anteil versiegelter Flächen an der Gesamtfläche von hoher Bedeutung. So können rechtliche Vorgaben eingehalten werden. Es sei erwähnt, dass die rechtlichen Vorgaben nicht rein abstrakt-rechtlicher Natur sind, sondern der Ermöglichung technischer Wirkungen dienen (einschließlich der Vermeidung unerwünschter technischer Wirkungen). Der Anteil versiegelter Flächen ist relevant für das Gesamtsystem, beispielsweise bei hohem Niederschlag, welcher in den Boden abfließen ("versickern") soll, ohne das Gesamtsystem zu stören, zerstören oder negativ zu beeinflussen. Überflutungen stellen ein großes Problem für die Menschen dar und stören die Nachhaltigkeit der baulichen Entwicklung offensichtlicher Weise vehement. Gemäß der Weiterbildung kann so das Potential der baulichen Nutzung weiter ausgeschöpft werden, ohne das physikalische System und seine vorgesehene Funktions- und Nutzweise zu gefährden. Ein unzulässiges Überschreiten kritischer Grenzwerte wird so beispielsweise im Vorfeld vermieden.

Gemäß der vorliegenden Erfindung umfasst das Verfahren ferner einen Schritt eines Bestimmens eines Bodenreferenzpunktes durch Erkennen eines Objektes in den Photogrammetriedaten, welches dazu geeignet ist, als Bodenreferenzpunkt zu dienen, insbesondere Schacht- und Kanaldeckel. Es können auch mehrere Objekte sein.

So ist der Bodenreferenzpunkt abermals präziser bestimmt, und näher an den tatsächlichen Gegebenheiten, welche im physikalischen System vorliegen und aus den Messdaten bestimmt werden sollen. Eine präzisere Bestimmung des Bodenreferenzpunktes kann sich auch stark auf derivate Größen auswirken wie First-, Traufhöhe, Geschossigkeit. Zudem kann unterschiedlichen Definitionen von (z.B. weil diese unterschiedlichen Definitionen baurechtlich relevant und zu berücksichtigen sind) Bodenreferenzpunkten entsprochen werden. Wenn ein Bodenreferenzpunkt beispielsweise als Schachtdeckel zur Kanalisation definiert ist, kann dies so gemessen bzw. aus den Messdaten bestimmt werden. Ist es, in einem anderen Beispiel, die Höhe eines Bordsteins bzw. einer Bordsteinkante, kann auch dieser Maßdefinition mithilfe der Photogrammetriedaten entsprochen werden.

Gemäß einer Weiterbildung umfasst das Verfahren ferner einen Schritt eines Verschneidens der Ausmaße des erkannten Objektes mit den n-dimensionalen Punktdaten zur Erzeugung von Verschnittpunktdaten. Beispielsweise werden nur LIDAR-Punktdaten im entsprechenden Bereich zur Bestimmung eines Referenzpunktes herangezogen, beispielsweise die Punkte oberhalb bzw. im Bereich des Schacht- oder Kanaldeckels (eines "Gullis").

Gemäß einer Weiterbildung umfasst das Verfahren ferner einen Schritt eines Bildens eines Durchschnittes der Verschnittpunktdaten zur Bestimmung des Bodenreferenzpunktes. Die Bildung des Durchschnittes über einen wohlgewählten Satz an Datenpunkten reduziert abermals den Fehler und führt zur hochpräzisen Bestimmung des Bodenreferenzpunktes sowie allen derivaten, hiervon abhängigen zu bestimmenden Größen.

Gemäß einer Weiterbildung umfasst das Verfahren ferner einen Schritt eines Verschneidens von n-dimensionalen Punktdaten mit einem durch die Sekundärdaten definierten

Gebäudeteil eines Teilsystems zur Erzeugung von Verschnittpunktdaten sowie einen Schritt eines Markierens der Punkte der Verschnittpunktdaten, welche in den Bereich des Gebäudeteils fallen, in den n-dimensionalen Punktdaten. So werden alle Punkte markiert, welche im Bereich bzw. oberhalb des Gebäudes liegen, so wie es im Kataster definiert ist. Diese Technik hat zahlreiche Vorteile.

Um beispielsweise bestimmte Größen des Hauses möglichst genau aus LIDAR-Daten zu bestimmen, können zum Beispiel LIDAR-Punkte ausgewählt werden, welche, wenn in die zweidimensionale Ebene projiziert, über dem Grundstück liegen. Hierdurch wird die Genauigkeit der derivaten Messgrößen erhöht, da Fehlerquellen abgeschnitten und hierdurch vermieden werden können. Beispielsweise wird so ein Baum in der Nähe des Hauses nicht berücksichtigt, wenn beispielsweise First- und Traufhöhe des Daches bestimmt werden sollen.

In einem weiteren Beispiel erhöht sich hierdurch die Genauigkeit in rechtlicher Hinsicht. In vielen Gebieten kann eine Traufhöhe eines Daches baurechtlich so definiert sein, dass sie auch bei einem überstehenden Dach exakt am Rande des bebauten Grundstückes zu messen ist. Da durch das Verschneiden ein über den Rand des bebauten Grundstückes überstehendes Dach abgeschnitten wird, erhöht sich die Genauigkeit der Bestimmung der Größe, welche baurechtlich als besonders relevant eingestuft wird. Die relevanten, verschnittenen Punkte können datentechnisch besonders markiert werden, sodass sich eine erneute Bestimmung erübrigt. Hierdurch wird Rechenzeit gespart, da die relevanten Datenpunkte durch die hieran angebrachten Flags unmittelbar für weitere Berechnungen zur Verfügung stehen.

Aus den Punktdaten, insbesondere den verschnittenen Punktdaten, können Normalenvektoren und Krümmungen (Curvature) bestimmt werden. Dies sind hilfreiche Größen für eine Vielzahl an Folgeberechnungen, weshalb es Rechenzeit und Ressourcen einspart, diese Quantitäten bereitzuhalten. Zudem sind Normalenrichtungen und Winkel, gleich ob in diskreter oder kontinuierlicher Form, wie beispielsweise bei einem Runddach, architektonisch relevante Größen.

Das oben beschriebene Beispiel funktioniert besonders solide, wenn die Gebäudeumrissen, beispielsweise aus den ALKIS-Daten, sehr präzise bekannt sind. Das Verfahren ist daher beispielsweise das bevorzugte Verfahren der Wahl für Deutschland, in dem die Gebäudeumrisse im Rahmen der ALKIS-Daten sehr präzise vermessen wurden.

Es sei an dieser Stelle noch auf weitere Anwendungen der Weiterbildung der Erfindung eingegangen. Wie bereits weiter oben diskutiert wurde, kann in einem weiteren Beispiel auch ein spezielles, hierzu speziell trainiertes, Machine-Learning-Modell dazu eingesetzt werden, aus den Punktdaten möglichst präzise die Gebäude, Gebäudeumrisse und/oder derivate Größen wie beispielsweise die First- und/oder Traufhöhe etc. zu bestimmen. Diese Vorgehensweise ist besonders präzise und deckt auch "Ausreißerfälle" wie Besonderheiten nicht-konventioneller Gebäude, souverän ab. Beispielsweise kommt ein Künstliches Neuronales Netz als Machine-Learning-Modell zum Einsatz.

In einem Beispiel wird das Machine-Learning-Modell mit Daten aus Deutschland trainiert. In Deutschland sind die Gebäudeumrissdaten aus den ALKIS-Daten mit vergleichsweise recht hoher Präzision verfügbar. Sodann kann das trainierte Machine-Learning-Modell hervorragend auch in Regionen des Auslands zum Einsatz gebracht werden, wo die Gebäudeumrisse nicht so genau bekannt sind bzw. vermessen wurden, und daher nicht so präzise im Rahmen von Katasterdaten verfügbar sind. Hierdurch wird die Präzision nicht nur insgesamt erhöht, die Präzision kann insbesondere souverän mit dem Machine-Learning-Modell auf geographische Regionen ausgeweitet werden, in denen hinreichend präzise Daten nicht verfügbar sind.

Durch die beschriebene Weiterbildung werden so wertvolle Trainingsdaten geschaffen, welche das Training des genannten Machine-Learning-Modells ermöglichen, und dadurch die hiermit ermöglichten genannten technischen Effekte zu bewerkstelligen vermögen.

Gemäß einer Weiterbildung findet ferner auf der Menge der Verschnittpunktdaten eine Klassifikation und Markierung von Punkten als Dachpunkte statt, insbesondere ein Clustering und/oder durch unüberwachtes Lernen, insbesondere auf Basis des euklidischen Abstandes der Punkte zueinander als relevantes Maß und/oder auf Basis des Vertikalabstandes, insbesondere der Vertikal- bzw. z-Komponente, der Punkte zueinander als relevantes Maß.

Dieses Vorgehen reduziert den Einfluss von Teilen der Punktwolke, welche nicht zum eigentlichen Dach gehören. Beispielsweise kann so ein Schornstein oder eine über das

Dach ragende Krone eines Baumes "weggeclustert" und so für die Bestimmung des Daches unschädlich gemacht werden. In einem Beispiel werden auch Dachgauben "weggeclustert", in einem anderen Beispiel werden solche Gauben bewusst als Teil des Daches beibehalten.

Beispielsweise wird als Maß für das Clustering der euklidische Abstand (oder sein Quadrat oder eine andere, äquivalente, vom euklidischen Abstand abhängige Größe) zweier Punkte der Punktwolke verwendet. Dies ist ein räumlich isotropes Maß und bringt so den Vorteil mit sich, dass die Ergebnisse rotationsinvariant sind. Auch Normalenvektoren sind für das Clustering gut geeignet.

Es hat sich gezeigt, dass im Hinblick auf eine souveräne Trennung des Daches von nicht zum Dach im engeren Sinne gehörenden Bestandteilen der Punktwolke ein besonders geeignetes zu berücksichtigendes Maß durch den Vertikalabstand gegeben ist. Es wird also hierbei nach z-Komponente bzw. in vertikaler Richtung bzw. nach Abstand vom Boden (oder einer hierzu äquivalenten Größe) geclustert. Die so erzielten Ergebnisse sind besonders erfolgreich und präzise. Durch diesen überraschenden technischen Effekt stellt das Clustering nach z-Komponente eine bevorzugte Weiterbildung der Erfindung dar.

Das Clustering nach Normalenvektor, euklidischem Abstand und Vertikalabstand ist abermals präziser, wenn diese Größen beispielsweise gleichzeitig in einem Clusteringverfahren zum Einsatz gebracht werden. Sie können sich jedoch auch ergänzen, indem mehrere nachgelagerte Clusteringverfahren zum Einsatz gebracht werden, beispielsweise zunächst nach euklidischem Abstand (ggf. unter Berücksichtigung der Normalenvektoren) und sodann nach Vertikalabstand (ggf. ebenfalls unter Berücksichtigung der Normalenvektoren). So werden die Ergebnisse besonders präzise, da kleinere Aufbauten (z.B. ein Schornstein, Dachschächte, Klimaanlagen, Satellitenschüsseln, etc.) nach dem ersten Clusteringvorgang noch im als Dach erkannten Datensatz verbleiben kann, jedoch dann in einem sukzessiven Nach-Clustering (z.B. nach z-Komponente) souverän entfernt werden kann.

Durch das auf diese Art identifizierte Dach können präzise Größen in Bezug auf das Dach, das Gebäude und seine Nutzung bestimmt werden.

Beispielsweise kann ein Volumen des Gebäudes berechnet werden. Technisch erfolgt dies in besonders vorteilhafter Weise durch numerische Integration der z-Komponenten der Punktwolke über der relevanten Fläche. Dieses Ergebnis ist besonders präzise und vermeidet gleichzeitig, unnötige Modellannahmen, z.B. über eine Dachform etc., machen zu müssen. Zudem profitiert dieses Verfahren von einem zuvor besonders präzise und korrekt bestimmten Bodenreferenzpunkt (ground reference point). Durch diesen synergetischen Effekt reduzieren sich Fehler und Fehlerfortpflanzung signifikant und die Bestimmung der Größen, beispielsweise hier des Volumens, erfolgt mich noch weiter erhöhter Präzision.

Eine andere Größe, die auf diese Art präzise berechnet werden kann, ist der Floorspace, auch genannt Geschossfläche. Dies ist auch hilfreich zur korrekten Berechnung einer Geschossflächenzahl (GFZ). Ein besonders vorteilhaftes numerisches Verfahren zur Berechnung des Floorspace besteht in der numerischen Integration über die bebaute Fläche unter Division durch eine Geschosshöhe. Beispielsweise kann eine Geschosshöhe bekannt sein oder sie kann geschätzt werden, insbesondere in Abhängigkeit von einer Nutzungsart (z.B. Wohnen oder Gewerbe).

Das so durch numerische Integration erzielte Ergebnis ist besonders präzise und vermeidet gleichzeitig, unnötige Modellannahmen, z.B. über eine Dachform etc., machen zu müssen. Zudem profitiert dieses Verfahren von einem zuvor besonders präzise und korrekt bestimmten Bodenreferenzpunkt (ground reference point).

Ebenso ist eine Bestimmung nutzbarer Geschosse möglich. Als besonders geeignet hat sich ein Verfahren erwiesen, bei dem Querschnitte durch das Gebäude bzw. seine Punktwolke gebildet werden. Die Abstände der Querschnitte sind beispielsweise durch eine Geschosshöhe festgelegt. Beispielsweise kann eine Geschosshöhe bekannt sein oder sie kann geschätzt werden, insbesondere in Abhängigkeit von einer Nutzungsart (z.B. Wohnen oder Gewerbe). Querschnitte mit einer Querschnittsfläche überhalb eines bestimmten Schwellenwerts (Mindestfläche einer Geschossfläche) zählen sodann als Geschoss bei der Bestimmung der Anzahl der nutzbaren Geschosse. Lediglich beispielsweise kann eine solcher Schwellenwert mit fünf Quadratmetern angesetzt werden. Dies hilft, Fehlabschätzungen in Grenzbereichen (kurz an der Schwelle zum nächsten Geschoss) zu vermeiden. Es verstärkt zudem abermals die Vermeidung von Fehlern durch Aufbauten wie beispielsweise Schornsteine, sofern diese nicht erfolgreich bereits zuvor aus dem Dach bzw. der Dach-Punktwolke entfernt, d.h. "weggeclustert", wurden. Auch sind derartige Dachgeschossflächen erst ab einer bestimmten Größe wirtschaftlich signifikant nutzbar (z.B. wenn sich eine Vermietung als Zimmer oder Wohnung anbietet).

Bei der hier diskutierten "Dacherkennung" können auch Normalenvektoren und Krümmungen berücksichtigt werden. Hierdurch wird das Ergebnis abermals präziser. Beispielsweise sind Dächer in der Regel nur selten "gekrümmt".

Gemäß einer Weiterbildung umfasst das Verfahren ferner einen Schritt eines Klassifizierens und Markierens von Punkten als Dachpunkte auf Basis eines trainierten zweiten Machine-Learning-Modells, insbesondere zweiten Künstlichen Neuronalen Netzes.

Es hat sich gezeigt, dass auch für die Vornahme dieses Schritts der Einsatz eines Machine-Learning-Modells anderen Strategien überlegen sein kann. So wird die Präzision abermals erhöht.

Wie an anderer Stelle erläutert ist, kann dies einen besonders gewinnbringenden Einsatz finden, wenn in einer geographischen Region von Interesse beispielsweise die Umrisse von Gebäude nicht genau vermessen wurden und daher nicht genau bekannt sind.

Gemäß einer Weiterbildung in diesem Zusammenhang wird und/oder wurde das zweite Machine-Learning-Modell trainiert durch ein Verfahren umfassend einen Schritt eines Verschneidens von n-dimensionalen Punktdaten mit einem durch Sekundärdaten definierten Gebäudeteil eines Teilsystems zur Erzeugung von Verschnittpunktdaten.

Dies erhöht die Präzision. Beispielsweise können so auch Daten in einer geographischen Region, wo Gebäudeumrisse präzise vermessen wurden (z.B. Deutschland), mit der Verschneidetechnik unter Erzeugung der Verschnittpunktdaten genutzt werden. Mit diesen Daten kann dann das (zweite) Machine-Learning-Modell so trainiert werden, dass es ebenfalls in anderen Regionen eigenständig die erfindungsgemäße Klassifikation vornehmen kann, ohne auf Daten präziser Gebäudeumrisse, welche in vielen relevanten geographischen Regionen insbesondere nicht flächendeckend akkurat verfügbar sind, angewiesen zu sein.

Gemäß einer Weiterbildung findet ferner auf der Menge der Verschnittpunktdaten eine Klassifikation und Markierung von Punkten als Dachpunkte statt, insbesondere ein Clustering und/oder durch unüberwachtes Lernen, insbesondere auf Basis des euklidischen Abstandes der Punkte zueinander als relevantes Maß und/oder auf Basis des Vertikalabstandes, insbesondere der Vertikal- bzw. z-Komponente, der Punkte zueinander als relevantes Maß, und/oder auf Basis von Normalenvektoren.

Für die Vorteile dieser weiteren Merkmale wird auf die obige Diskussion verwiesen. Auch der Einsatz dieser Technik in Bezug auf die Erzeugung guter Trainingsdaten, um das zweite Machine-Learning-Modell zu trainieren, hat sich in der Praxis bewiesen und als äußerst vorteilhaft herausgestellt. Von der besseren und korrekteren Bestimmung von Dächern im Rahmen dieser Clusteringtechnik, deren Vorteile weiter oben bereits beschrieben wurden, können so sukzessive auch die Qualität der Trainingsdaten, hierdurch sodann die Qualität des Trainings des zweiten Machine-Learning-Modells und sodann zuletzt die Klassifikationsergebnisse für Dachpunkte unter dem bestimmungsgemäßen Einsatz des zweiten Machine-Learning-Modells profitieren.

Bei der hier diskutierten "Dacherkennung" können auch Krümmungen berücksichtigt werden. Hierdurch wird das Ergebnis abermals präziser. Beispielsweise sind Dächer in der Regel nur selten "gekrümmt".

Gemäß einer Weiterbildung umfasst ein eingehender Merkmalsvektor des Künstlichen Neuronalen Netzes einerseits grundstücksbezogene Sekundärdaten des ausgewählten Teilsystems sowie andererseits Teilsystemdaten von anderen, nicht ausgewählten Teilsystemen. Insbesondere relevant sind hierbei regelmäßig Teilsysteme in der näheren Umgebung.

Beispielsweise, aber nicht ausschließlich, umfassen solche grundstücksbezogenen Sekundärdaten eine Fläche, Lage, Form, Abmaße oder Nutzung (z.B. laut Flächennutzungsplan) eines Grundstückes.

Beispielsweise, aber nicht ausschließlich, umfassen solche Teilsystemdaten von anderen, nicht ausgewählten Teilsystemen, Daten wie Grundflächenzahl, Geschossflächenzahl, Firsthöhe, Traufhöhe, Volumen, Anzahl nutzbarer Geschosse, Dachwinkel, Fläche, Lage, Form oder Abmaße eines Grundstückes, Anzahl der Vollgeschosse, Nutzungsart (z.B. laut Flächennutzungsplan) uvm.

Sämtliche im vorliegenden Patentdokument erwähnten Größen in Bezug auf Grundstücke und/oder Gebäude können potenziell in den Teilsystemdaten enthalten sein.

So kann das Künstliche Neuronale Netz mit entsprechenden Daten dazu trainiert werden, passende Vorhersagen bzw. Vorschläge zu machen.

Vereinfach gesagt wird das Gebäude auf dem Grundstück, welches betrachtet wird (vgl. ausgewähltes Teilsystem) schlicht nicht in der Berechnung berücksichtigt, sodann kann das Künstliche Neuronale Netz für einen Vorschlag bzw. eine Vorhersage benutzt werden. Dabei berücksichtigt es sämtliche relevante "Umgebungsfaktoren". Diese sind einerseits Eigenschaften des Grundstückes (vgl. Sekundärdaten des ausgewählten Teilsystems). Andererseits sind dies die Grundstücke samt Gebäuden und deren Eigenschaften in der Umgebung, insbesondere der näheren Umgebung (Teilsystemdaten der anderen Teilsysteme). Diese Strukturierung in Bezug auf Eingang- und Ausgangsgrößen erlaubt eine besonders effiziente und gezielte Nutzung des Künstlichen Neuronalen Netzes und eine besonders gute Steuerung der dynamischen Verbesserung, welche im Ergebnis erfindungsgemäß am System vollzogen werden kann. Beispielsweise werden so Volumen- und Flächenressourcen in einer Siedlung oder einer Agglomeration durch wiederholten Einsatz der Erfindung sukzessive immer besser ausgenutzt. Dabei wird die Systemhomogenität gewahrt - und im Falle von Baurechtsvorgaben können diese automatisch berücksichtigt und hierdurch eingehalten werden.

Gemäß einer Weiterbildung werden gebäudebezogene Sekundärdaten des ausgewählten Teilsystems durch das Künstliche Neuronale Netz vorhergesagt.

Es hat sich herausgestellt, dass das Künstliche Neuronale Netz dazu geeignet ist, passende Vorschläge zu machen, die das Potential - in realen Fällen - deutlich besser ausschöpfen als andere Methoden. Das Künstliche Neuronale Netz kann in enorm hochdimensionalen Merkmalsräumen (feature spaces) "denken", und hierdurch Korrelationen in diesen Räumen finden und berücksichtigen, welche durch manuellen oder anderweitig automatisierten Zugang kaum zu erfassen sind, und daher unberücksichtigt bleiben. Es wurden Vergleichsstudien sowie Studien an reellen Samples wie beispielsweise bereits gebauten, insbesondere kürzlich gebauten, Gebäuden durchgeführt. Bei diesen Gebäuden wurden beispielsweise enorme Investitionen getätigt und eine Vielzahl an Professionellen/Experten für lange Zeit beschäftigt, um dafür Sorge zu tragen, dass eine Lösung gefunden wird, welche die externen Voraussetzungen und Anforderung erfüllt und gleichzeitig das derzeit vorhandene Potential identifiziert und möglichst vollständig ausschöpft. Dabei konnten durch das Künstliche Neuronale Netz viele der Ergebnisse reproduziert werden. In einigen Fällen konnten die Ergebnisse der Professionellen durch die Erfindung mit ihrem Künstlichen Neuronalen Netz stark übertroffen werden. Es ist also zu konstatieren, dass sowohl eine manuelle Systemoptimierung als auch eine anderweitig computerautomatisierte Systemverbesserung in wichtigen Fällen von der KI im Ergebnis übertroffen wird.

Gemäß einer Weiterbildung umfasst das Verfahren ferner einen Schritt eines Messens mindestens eines Punktdatums mittels LIDAR, insbesondere durch eine flugfähige Messvorrichtung.

Die Daten können also auch im Rahmen der Erfindung selbst gemessen und datentechnisch erfasst werden. Dies hat den Vorteil, dass Erfassungsparameter - beispielsweise Auflösungen oder Wiederholungsraten - an den beabsichtigten Zweck angepasst werden können. Es können auch selbst gemessene mit bereits vorhandenen Daten, zum Beispiel zwecks Genauigkeitserhöhung, kombiniert werden. Die frisch gemessenen Daten sind auch aktueller und repräsentieren daher exakter die tatsächliche Beschaffenheit des physikalischen Systems, verglichen mit beispielsweise behördlichen Daten, welche mehrere Jahre alt sein können.

Gemäß einer Weiterbildung umfasst das Verfahren ferner einen Schritt eines Identifizierens von Verbesserungspotentialen durch ein Vergleichen von Kenngrößen des ausgewählten Teilsystems in existenter Form mit Kenngrößen des ausgewählten Teilsystems in der vom Künstlichen Neuronalen Netz vorgeschlagenen Form, insbesondere durch ein Vergleichen von Maßen der baulichen Nutzung.

So können Potentiale übersichtlich erfasst und sogar "gesucht" werden. Der Vergleich von Ist- und Sollgrößen erlaubt eine sinnvolle Quantifikation des Potentials, welches sich hinter der Optimierung von Teilsystemen verbirgt. So kann die Erfindung auch als eine Erfindung der Regelungs- und Steuerungstechnik eingesetzt bzw. betrachtet werden.

Gemäß einer Weiterbildung umfasst das Verfahren ferner einen Schritt eines graphischen Darstellens einer Karte, welches für zwei oder mehrere Teilsysteme Verbesserungspotentiale für den Nutzer (optisch) wahrnehmbar graphisch indiziert.

Eine solche Darstellung ist für den Nutzer sehr hilfreich und übersichtlich. Der Effekt, dass eine grafische Darstellung der Verbesserungspotentiale auf einer Art von Karte oder einer Systemübersicht die Wahrnehmung, Verarbeitung und Reaktion der Nutzer auf die Ergebnisse führt, konnte uns von weiten Kreisen unserer Nutzer aus den verschiedensten Nutzergruppen bestätigt werden.

Es sind verschiedenste konkrete Arten der graphischen Darstellungen der Teilsysteme und der zugehörigen Verbesserungspotentiale denkbar. Die Erfindung beabsichtigt nicht, sich lediglich auf eine konkrete Art der graphischen Darstellung festzulegen. Es ist nebensächlich, ob Balken-, Kreisdiagramme oder andere Arten der Darstellung zum Einsatz kommen. Beispielsweise kann sich auch ein Nutzer zwischen verschiedenen möglichen Arten der graphischen Darstellung eine für ihn passende aussuchen, welche seinem persönlichen Geschmack entspricht oder für ihn besonders intuitiv und leicht verständlich ist.

Gemäß einer Weiterbildung umfasst das Verfahren ferner einen Schritt eines Anpassens des physikalischen Systems durch Veränderung des ausgewählten Teilsystems, in der vom Künstlichen Neuronalen Netz vorgeschlagenen Form, insbesondere durch Bau, Umbau oder Neubau einer oder mehrerer Gebäudestrukturen im ausgewählten Teilsystem.

Hierdurch wird das System sukzessive verbessert und, unter Einhaltung von Anforderungen, nachhaltig in der Fortentwicklung gesteuert. Die Erkenntnis von Potentialen, und auch deren Umsetzung, gibt unseren Nutzern enorme Wettbewerbsvorteile und zuletzt dadurch auch finanzielle Vorteile, gegenüber Parteien, welche über die technische Analyse und Informationen zur Systemverbesserung nicht verfügen.

Gemäß einer Weiterbildung umfasst das Verfahren ferner einen Schritt eines Clusterings von Teilsystemen zu zusammengehörigen Clustern und entsprechendes Markieren der Teilsysteme in Bezug auf ihre Clusterzugehörigkeit, insbesondere unter Nutzung einer Kl-Technik eines unüberwachtem Lernens.

Innerhalb von Teilsystemclustern sind in Systemen mit Homogenitätsanforderungen die letzteren besonders stark zu berücksichtigen. Cluster dürfen also beispielsweise

Unterschiede zueinander aufweisen, während die Anwendung einer Homogenitätsregel innerhalb des Clusters ausgeprägter sein kann, ohne die korrekte Funktion und Ordnung des Systems zu gefährden. Häufig unterliegen bestimmte Cluster von Gebäuden, z.B. Gebäudegruppen, den gleichen oder ähnlichen baurechtlichen Anforderungen, und eine Einfügung eines individuellen Gebäudes in den zugehörigen Cluster, nicht aber andere Cluster, ist erforderlich bzw. erwünscht. Dies kann insbesondere an Clustergrenzen relevant sein. So kann auch beispielsweise ein Wohn- an ein Gewerbegebiet grenzen. Für Häuser in diesem Grenzgebiet sind die unmittelbaren Nachbarn nicht notwendigerweise relevant, wenn diese zu einem anderen Cluster gehören. Die Clusterzugehörigkeit ist hier also besonders wichtig. Ähnliches gilt beispielsweise für Bauteile oder Teile von Bauteilen in der Mikro- bzw. Nanoelektronik.

Gemäß einer Weiterbildung umfassen die Teilsystemdaten eines oder mehrere aus: Firsthöhe, Traufhöhe, Höhe eines Daches, Dachwinkel, Grundflächenzahl GRZ, Grundflächenzahl GRZ1, Grundflächenzahl GRZ2, Geschossflächenzahl GFZ, Geschossfläche, Volumen, Anzahl nutzbarer Geschosse, Anzahl der Vollgeschosse, Vorhandensein und Ausmaß versiegelter Flächen, Bodenreferenzpunkt, Region, Stadt und/oder Kreis, in dem/der sich das Teilsystem befindet, Maß der baulichen Nutzung eines nächsten Nachbarn, Maß der baulichen Nutzung eines m-nächsten (zweitnächsten, drittnächsten, etc.) Nachbarn, eine Boolesche Aussage dazu, ob der nächste Nachbar an einer selben Verbindung, insbesondere einer selben Straße, lokalisiert ist wie das ausgewählte Teilsystem, eine Boolesche Aussage dazu, ob der m-nächste Nachbar an einer selben Verbindung, insbesondere einer selben Straße, lokalisiert ist wie das ausgewählte Teilsystem, eine Boolesche Aussage dazu, ob der nächste Nachbar eine offene oder geschlossene Bauweise hat, eine Boolesche Aussage dazu, ob der m-nächste Nachbar eine offene oder geschlossene Bauweise hat, eine Boolesche Aussage dazu, ob der nächste Nachbar ein Gebäude im Hof oder an der Straße aufweist, eine Boolesche Aussage dazu, ob der m-nächste Nachbar ein Gebäude im Hof oder an der Straße aufweist, eine Längenangabe, welche eine Entfernung des Gebäudes des nächsten Nachbarn zur Straße bestimmt, eine Längen- und/oder Tiefenangabe, welche bestimmt, wie tief ein Haus grundstückeinwärts in Bezug auf die Straße gebaut ist, einschlägiges Baugebiet, einschlägige Bebauungspläne, Flächennutzungsplan, Nutzungsvorschriften nach gesetzlichen Vorgaben, insbesondere Baunutzungsverordnung, Clusterzugehörigkeit des Teilsystems zu einem Cluster von Teilsystemen.

Dies sind lediglich Beispiele, jedoch solche, die sich für die Anwendung der vorliegenden Erfindung auf Gebäude als besonders relevant herausgestellt haben. Hierdurch wird eine besonders präzise Vorhersage von Eigenschaften zu errichtender Gebäude erreicht.

m bezeichnet eine natürliche Zahl. Sie ist ansonsten frei wählbar. Es können also sämtliche Nachbarn, für m in prinzipiell beliebiger Größe, berücksichtigt werden (jeweils in Kombinationen sämtlicher ihrer Eigenschaften oder Teilen davon) oder eben nicht.

Beispielsweise können für endlich viele Nachbarn individuelle Teilmengen der folgenden Eigenschaften berücksichtigt werden: Firsthöhe, Traufhöhe, Höhe eines Daches, Dachwinkel, Grundflächenzahl GRZ, Grundflächenzahl GRZ1, Grundflächenzahl GRZ2, Geschossflächenzahl GFZ, Geschossfläche, Volumen, Anzahl nutzbarer Geschosse, Anzahl der Vollgeschosse, Vorhandensein und Ausmaß versiegelter Flächen, Bodenreferenzpunkt, Region, Stadt und/oder Kreis, uvm.

Ein Maß der baulichen Nutzung kann beispielsweise sein: GRZ oder GFZ.

Auch Aussagen welche Relationsdaten betreffen (welche mindestens eine Eigenschaft umfassen, die eine Relation zwischen dem ausgewählten Teilsystem und anderen Teilsystemen, insbesondere nichtausgewählten Teilsystemen, beschreibt), können für endlich viele Nachbarn berücksichtigt werden oder eben nicht. Die Relationen können in der Praxis beliebig komplexer Natur sein. Lediglich beispielhaft für eine solche Relation sei das einfache Beispiel erwähnt, bei dem die Aussage die Relation beschreibt, ob das ausgewählte Teilsystem und ein bestimmter m-nächster Nachbar sich "in derselben Straße" befinden (ja bzw. nein).

Es sei abermals betont, dass hier beliebig komplexe derivate Größen auf Basis der Relation von ausgewähltem und nicht-ausgewähltem Teilsystem möglich sind.

Auch die Relationen können auf grundstücksbezogene (d.h. sekundärdatenbezogene) Eigenschaften der Teilsysteme Bezug nehmen.

Gemäß einer Weiterbildung geschieht der Schritt des Nutzens des Machine-Learning-Modells, insbesondere des Künstlichen Neuronalen Netzes, ferner auf Basis von Relationsdaten, welche mindestens eine Eigenschaft umfassen, die eine Relation zwischen dem ausgewählten Teilsystem und anderen Teilsystemen, insbesondere nichtausgewählten Teilsystemen, beschreibt.

Durch die Einbeziehung von Relationsdaten wird die Berechnung abermals präziser, da Homogenitätsanforderungen abermals besser Rechnung getragen werden kann. So kann - lediglich beispielsweise - berücksichtigt werden, ob ein ausgewähltes Teilsystem und ein anderes Teilsystem an einer gleichen Straße liegen oder zu einer gleichen Wohnsiedlung gehören. Es wird in diesem Zusammenhang auf die detaillierten Beschreibungen weiter oben verwiesen

Gemäß einer Weiterbildung umfasst das Verfahren ferner einen Schritt eines Erzeugens von LoD-Daten auf Basis der n-dimensionalen Punktdaten, insbesondere LIDAR-Daten, wobei der Schritt des Bestimmens von Teilsystemdaten auf Basis der erzeugten LoD-Daten erfolgt.

So können LoD-Daten (Level of Detail, Detaillierungsgraddaten) effizient erzeugt werden. Dies reduziert die Komplexität der Daten und vereinfacht die weitere Datenverarbeitung. Durch die verschiedenen Detaillierungsgrade wird ein einfacher Zugriff auf makroskopische Größen in der Graden niedriger Detaillierung ermöglicht, während Details durch die höheren Detaillierungsgrade sichergestellt werden.

In einem Beispiel kommt das CityGML-Format zum Einsatz. Dies ist flexibel einsetzbar und erhöht die Kompatibilität und Interoperabilität zwischen Programmmodulen als auch im Hinblick auf externe Interfaces.

Durch die Nutzung der Erfindung kann Wohnraum (sowie anderweitig genutzte Flächen bzw. Volumen) effizient nachverdichtet werden. Hierdurch kann zudem eine Neuversiegelung von Flächen vermieden werden, da durch die Nutzung der vorliegenden Erfindung existente Flächen nachverdichtet und/oder umgewidmet werden können, bevor Neuversiegelungen (z.B. von Behörden) in Betracht gezogen werden.

Da die Nachverdichtung zumeist auf bereits versiegelten oder errichteten Gebäuden stattfindet, wird mit der Technologie der Neuversiegelung entgegengewirkt und somit ein wichtiger Beitrag zum ökologischen Städtebau geleistet. Die Erfindung leistet so auch eine Reduktion von klimaschädlichen CO2-Emissionen. Das Klima kann so nachhaltig positiv beeinflusst werden, insbesondere wenn genügend Stakeholder sich die vorliegende Erfindung zunutze machen.

Des Weiteren können bei Aufstockungen jeglicher Art Leichtbaumaterialien wie Vollholzkonstruktionen verwendet werden, um mehr Wohnraum auf weniger Fläche zu generieren. Mit der Erfindung wird so einer verantwortungsvollen Art der Nachverdichtung Sorge getragen.

Die Erfindung schafft zudem Computer, Computerprogramme, Computernetzwerke, Daten und computerlesbare Datenträger sowie ein Verfahren zum Trainieren eines erfindungsgemäßen Künstlichen Neuronalen Netzwerkes.

Sämtliche im Zusammenhang mit entsprechenden Verfahren offenbarte Merkmale können im Zusammenhang mit den Vorrichtungen und Computerprogrammen zum Einsatz gebracht werden, als auch umgekehrt.

Obwohl einige Aspekte im Rahmen einer Vorrichtung beschrieben wurden, ist es klar, dass diese Aspekte auch eine Beschreibung des entsprechenden Verfahrens darstellen, wobei ein Block oder eine Vorrichtung einem Verfahrensschritt oder einer Funktion eines Verfahrensschritts entspricht. Analog dazu stellen Aspekte, die im Rahmen eines Verfahrensschritts beschrieben werden, auch eine Beschreibung eines entsprechenden Blocks oder Elements oder einer Eigenschaft einer entsprechenden Vorrichtung dar.

Ausführungsbeispiele der Erfindung können in einem Computersystem realisiert werden. Das Computersystem kann eine lokale Computervorrichtung (z.B. Personalcomputer, Laptop, Tablet-Computer oder Mobiltelefon) mit einem oder mehreren Prozessoren und einer oder mehreren Speichervorrichtungen oder kann ein verteiltes Computersystem (z.B. ein Cloud-Computing-System mit einem oder mehreren Prozessoren oder einer oder mehreren Speichervorrichtungen, die an verschiedenen Stellen verteilt sind, zum Beispiel an einem lokalen Client und/oder einer oder mehreren Remote-Server-Farms und/oder Datenzentren) sein. Das Computersystem kann irgendeine Schaltung oder Kombination von Schaltungen umfassen. Bei einem Ausführungsbeispiel kann das Computersystem einen oder mehrere Prozessoren umfassen, die von irgendeinem Typ sein können. Nach hiesigem Gebrauch kann Prozessor irgendein Typ von Rechenschaltung bedeuten, wie beispielsweise, aber nicht beschränkt auf, ein Mikroprozessor, ein Mikrocontroller, ein Mikroprozessor mit komplexem Befehlssatz (CISC), ein Mikroprozessor mit reduziertem Befehlssatz (RISC), ein Sehr-langes-Anweisungswort- (Very Long Instruction Word; VLIW) Mikroprozessor, ein Graphikprozessor, ein digitaler Signalprozessor (DSP), ein Multi-Core-Prozessor, ein feld-programmierbares Gate-Array (FPGA) oder irgendein anderer Typ von Prozessor oder Verarbeitungsschaltung. Andere Typen von Schaltungen, die in dem Computersystem umfasst sein können, können eine speziell angefertigte Schaltung, eine anwendungsspezifische integrierte Schaltung (ASIC) oder Ähnliches, wie beispielsweise eine oder mehrere Schaltungen (z. B. eine Kommunikationsschaltung) zur Verwendung bei drahtlosen Vorrichtungen wie z. B. Mobiltelefonen, Tablet-Computern, Laptop-Computern, Funksprechgeräten und ähnlichen elektronischen Systemen sein. Das Computersystem kann eine oder mehrere Speichervorrichtungen umfassen, die ein oder mehrere Speicherelemente umfassen können, die für die jeweilige Anwendung geeignet sind, wie beispielsweise einen Hauptspeicher in der Form eines Direktzugriffsspeichers (RAM, Random Access Memory), eine oder mehrere Festplatten und/oder ein oder mehrere Laufwerke, die entfernbare Medien, wie beispielsweise CDs, Flash-Speicherkarten, DVD und Ähnliches handhaben. Das Computersystem kann auch eine Anzeigevorrichtung, einen oder mehrere Lautsprecher, und eine Tastatur und/oder Steuerung umfassen, die eine Maus, Trackball, Touchscreen, Stimmerkennungsvorrichtung oder irgendeine andere Vorrichtung umfassen kann, die es einem Systemnutzer erlaubt, Information in das Computersystem einzugeben und Information von demselben zu empfangen.

Einige oder alle Verfahrensschritte können durch (oder unter Verwendung) einer Hardwarevorrichtung ausgeführt werden, wie es zum Beispiel ein Prozessor, ein Mikroprozessor, ein programmierbarer Computer oder eine elektronische Schaltung sein kann. In einigen Ausführungsbeispielen können ein oder mehrere der wichtigsten Verfahrensschritte durch eine solche Vorrichtung ausgeführt werden.

Abhängig von bestimmten Implementierungsanforderungen können Ausführungsbeispiele der Erfindung in Hardware oder Software implementiert werden. Die Implementierung kann mit einem nicht-flüchtigen Speichermedium wie einem digitalen Speichermedium, wie beispielsweise einer Diskette, einer DVD, einem Blu-Ray, einer CD, einem ROM, einem PROM und EPROM, einem EEPROM oder einem FLASH-Speicher, durchgeführt werden, auf dem elektronisch lesbare Steuersignale gespeichert sind, die mit einem programmierbaren Computersystem so zusammenwirken (oder zusammenwirken können), dass das jeweilige Verfahren durchgeführt wird. Daher kann das digitale Speichermedium computerlesbar sein.

Einige Ausführungsbeispiele gemäß der Erfindung umfassen einen Datenträger mit elektronisch lesbaren Steuersignalen, die mit einem programmierbaren Computersystem zusammenwirken können, so dass eines der hierin beschriebenen Verfahren durchgeführt wird.

Im Allgemeinen können Ausführungsbeispiele der vorliegenden Erfindung als Computerprogrammprodukt mit einem Programmcode implementiert werden, wobei der Programmcode für die Ausführung eines der Verfahren wirksam ist, wenn das Computerprogrammprodukt auf einem Computer läuft. Der Programmcode kann beispielsweise auf einem maschinenlesbaren Träger gespeichert werden.

Weitere Ausführungsbeispiele umfassen das Computerprogramm zur Durchführung eines der hierin beschriebenen Verfahren, das auf einem maschinenlesbaren Träger gespeichert ist.

Mit anderen Worten, ein Ausführungsbeispiel der vorliegenden Erfindung ist daher ein Computerprogramm mit einem Programmcode zur Durchführung eines der hierin beschriebenen Verfahren, wenn das Computerprogramm auf einem Computer läuft.

Ein weiteres Ausführungsbeispiel der vorliegenden Erfindung ist daher ein Speichermedium (oder ein Datenträger oder ein computerlesbares Medium), das ein darauf gespeichertes Computerprogramm zum Ausführen eines der hierin beschriebenen Verfahren umfasst, wenn es von einem Prozessor ausgeführt wird. Der Datenträger, das digitale Speichermedium oder das aufgezeichnete Medium sind in der Regel greifbar und/oder nicht übergangslos. Eine weiteres Ausführungsbeispiel der vorliegenden Erfindung ist eine Vorrichtung, wie hierin beschrieben, die einen Prozessor und das Speichermedium umfasst.

Ein weiteres Ausführungsbeispiel der Erfindung ist daher ein Datenstrom oder eine Signalfolge, die das Computerprogramm zur Durchführung eines der hierin beschriebenen Verfahren darstellt. Der Datenstrom oder die Signalfolge kann beispielsweise so konfiguriert werden, dass sie über eine Datenkommunikationsverbindung, beispielsweise über das Internet, übertragen werden.

Ein weiteres Ausführungsbeispiel umfasst ein Verarbeitungsmittel, zum Beispiel einen Computer oder eine programmierbare Logikvorrichtung, das konfiguriert oder angepasst ist, um eines der hierin beschriebenen Verfahren auszuführen.

Ein weiteres Ausführungsbeispiel umfasst einen Computer, auf dem das Computerprogramm zum Ausführen eines der hierin beschriebenen Verfahren installiert ist.

Ein weiteres Ausführungsbeispiel gemäß der Erfindung umfasst eine Vorrichtung oder ein System, das konfiguriert ist, um (zum Beispiel elektronisch oder optisch) ein Computerprogramm zum Ausführen eines der hierin beschriebenen Verfahren an einen Empfänger zu übertragen. Der Empfänger kann beispielsweise ein Computer, eine mobile Vorrichtung, eine Speichervorrichtung oder dergleichen sein. Die Vorrichtung oder das System kann beispielsweise einen Dateiserver zum Übertragen des Computerprogramms an den Empfänger umfassen.

In einigen Ausführungsbeispielen kann eine programmierbare logische Vorrichtung (z.B. eine feldprogrammierbare Gatteranordnung, FPGA) verwendet werden, um einige oder alle Funktionalitäten der hierin beschriebenen Verfahren auszuführen. In einigen Ausführungsbeispielen kann eine feldprogrammierbare Gatteranordnung mit einem Mikroprozessor zusammenarbeiten, um eines der hierin beschriebenen Verfahren durchzuführen. Im Allgemeinen werden die Verfahren vorzugsweise von jedem Hardwaregerät durchgeführt.

Ausführungsbeispiele können auf dem Verwenden eines Maschinenlern-Modells/Machine-Learning-Modells oder Maschinenlern-Algorithmus, basieren. Maschinelles Lernen kann sich auf Algorithmen und statistische Modelle beziehen, die Computersysteme verwenden können, um eine bestimmte Aufgabe ohne Verwendung expliziter Anweisungen auszuführen, anstatt sich auf Modelle und Inferenz zu verlassen. Beim maschinellen Lernen kann beispielsweise anstatt einer auf Regeln basierenden Transformation von Daten, eine Transformation von Daten verwendet werden, die aus einer Analyse von Verlaufs- und/oder Trainings-Daten hergeleitet werden kann. Beispielsweise kann der Inhalt von Bildern unter Verwendung eines Maschinenlern-Modells oder unter Verwendung eines Maschinenlern-Algorithmus analysiert werden. Damit das Maschinenlern-Modell den Inhalt eines Bildes analysieren kann, kann das Maschinenlern-Modell unter Verwendung von Trainingsbildern als Eingabe und Trainingsinhaltsinformation als Ausgabe trainiert werden. Durch Trainieren des Maschinenlern-Modells mit einer großen Anzahl von Trainingsbildern und/oder Trainingssequenzen (z. B. Wörtern oder Sätzen) und zugeordneter Trainingsinhaltsinformation (z. B. Kennzeichnungen oder Anmerkungen) "Iernt" das Maschinenlern-Modell, den Inhalt der Bilder zu erkennen, sodass der Inhalt von Bildern, die in den Trainingsdaten nicht umfasst sind, unter Verwendung des Maschinenlern-Modells erkannt werden kann. Das gleiche Prinzip kann für andere Arten von Sensordaten ebenfalls verwendet werden: Durch Trainieren eines Maschinenlern-Modells unter Verwendung von Trainingssensordaten und einer erwünschten Ausgabe "Iernt" das Maschinenlern-Modell eine Umwandlung zwischen den Sensordaten und der Ausgabe, was verwendet werden kann, um eine Ausgabe basierend auf an das Maschinenlern-Modell bereitgestellten Nicht-Trainings-Sensordaten bereitzustellen. Die bereitgestellten Daten (z.B. Sensordaten, Metadaten und/oder Bilddaten) können vorverarbeitet werden, um einen Merkmalsvektor zu erhalten, welcher als Eingang für das Maschinenlern-Modell verwendet wird.

Maschinenlern-Modelle können unter Verwendung von Trainingseingabedaten trainiert werden. Die oben angeführten Beispiele verwenden ein Trainingsverfahren, das "Supervised Learning" genannt wird. Beim Supervised Learning wird das Maschinenlern-Modell unter Verwendung einer Mehrzahl von Trainingsabtastwerten trainiert, wobei jeder Abtastwert eine Mehrzahl von Eingabedatenwerten und eine Mehrzahl von erwünschten Ausgabewerten, d. h. jedem Trainingsabtastwert ist ein erwünschter Ausgabewert zugeordnet, umfassen kann. Durch Angeben sowohl von Trainingsabtastwerten als auch erwünschten Ausgabewerten "Iernt" das Maschinenlern-Modell, welcher Ausgabewert basierend auf einem Eingabeabtastwert, der ähnlich zu den während des Trainings bereitgestellten Abtastwerten ist, bereitzustellen ist. Neben dem Supervised Learning kann auch Semi-Supervised Learning verwendet werden. Beim Semi-Supervised Learning fehlt einigen der Trainingsabtastwerte ein erwünschter Ausgabewert. Supervised Learning kann auf einem Supervised Learning-Algorithmus basieren (z. B. einem Klassifizierungsalgorithmus, einem Regressionsalgorithmus oder einem Ähnlichkeitslernen-Algorithmus). Klassifizierungsalgorithmen können verwendet werden, wenn die Ausgaben auf eine begrenzte Menge von Werten (kategorische Variablen) beschränkt sind, d. h. die Eingabe ist als einer aus dem begrenzten Satz von Werten klassifiziert. Regressionsalgorithmen können verwendet werden, wenn die Ausgaben irgendeinen Zahlenwert (innerhalb eines Bereichs) ausweisen. Ähnlichkeitslernen-Algorithmen können sowohl Klassifizierungs- als auch Regressionsalgorithmen ähnlich sein, basieren aber auf dem Lernen aus Beispielen unter Verwendung einer Ähnlichkeitsfunktion, die misst, wie ähnlich oder verwandt zwei Objekte sind. Neben dem Supervised Learning oder Semi-Supervised Learning kann Unsupervised Learning verwendet werden, um das Maschinenlern-Modell zu trainieren. Beim Unsupervised Learning werden möglicherweise (nur) Eingabedaten bereitgestellt und ein Unsupervised Learning-Algorithmus kann verwendet werden, um eine Struktur in den Eingabedaten zu finden (z. B. durch Gruppieren oder Clustern der Eingabedaten, Finden von Gemeinsamkeiten in den Daten). Clustern ist die Zuweisung von Eingabedaten, die eine Mehrzahl von Eingabewerten umfassen, in Teilmengen (Cluster), sodass Eingabewerte innerhalb desselben Clusters gemäß einem oder mehreren (vordefinierten) Ähnlichkeitskriterien ähnlich sind, während sie Eingabewerten, die in anderen Clustern umfasst sind, unähnlich sind.

Verstärkendes Lernen ist eine dritte Gruppe von Maschinenlern-Algorithmen. Anders ausgedrückt, verstärkendes Lernen kann verwendet werden, um das Maschinenlern-Modell zu trainieren. Beim verstärkenden Lernen werden ein oder mehrere Software-Akteure (sogenannte "Software Agents") trainiert, um Handlungen in einer Umgebung vorzunehmen. Basierend auf den vorgenommenen Handlungen wird eine Belohnung berechnet. Verstärkendes Lernen basiert auf dem Trainieren des einen oder der mehreren Software Agents, um die Handlungen auszuwählen, derart, dass die kumulative Belohnung erhöht wird, was zu Software Agents führt, die in der Aufgabe, die ihnen gegeben wird, besser werden (wie durch steigende Belohnungen nachgewiesen).

Ferner können einige Techniken auf einige der Maschinenlern-Algorithmen angewandt werden. Zum Beispiel kann Feature Learning verwendet werden. Anders ausgedrückt, das Maschinenlern-Modell kann zumindest teilweise unter Verwendung von Feature Learning trainiert werden, und/oder der Maschinenlern-Algorithmus kann eine Feature Learning-Komponente umfassen. Feature Learning-Algorithmen, die Representation Learning-Algorithmen genannt werden, können die Information in ihrer Eingabe erhalten, sie aber derart transformieren, dass sie nützlich wird, häufig als Vorverarbeitungsstufe vor dem Ausführen der Klassifizierung oder dem Vorhersagen. Feature Learning kann beispielsweise auf einer Hauptkomponenten-Analyse oder Cluster-Analyse basieren.

Bei einigen Beispielen kann eine Anomaliedetektion (d. h. Ausreißer-Detektion) verwendet werden, die darauf abzielt, eine Identifizierung von Eingabewerten bereitzustellen, die Verdacht erregen, da sie sich erheblich von der Mehrheit von Eingabe- und Trainingsdaten unterscheiden. Anders ausgedrückt, das Maschinenlern-Modell kann zumindest teilweise unter Verwendung von Anomaliedetektion trainiert werden, und/oder der Maschinenlern-Algorithmus kann eine Anomaliedetektions-Komponente umfassen.

Bei einigen Beispielen kann der Maschinenlern-Algorithmus einen Entscheidungsbaum als Vorhersagemodell verwenden. Anders ausgedrückt, das Maschinenlern-Modell kann auf einem Entscheidungsbaum basieren. Bei einem Entscheidungsbaum können die Beobachtungen zu einem Gegenstand (z. B. einer Menge von Eingabewerten) durch die Zweige des Entscheidungsbaums dargestellt werden, und ein Ausgabewert, der dem Gegenstand entspricht, kann durch die Blätter des Entscheidungsbaums dargestellt werden. Entscheidungsbäume können sowohl diskrete Werte als auch fortlaufende Werte als Ausgabewerte unterstützen. Wenn diskrete Werte verwendet werden, kann der Entscheidungsbaum als Klassifizierungsbaum bezeichnet werden, wenn fortlaufende Werte verwendet werden, kann der Entscheidungsbaum als Regressionsbaum bezeichnet werden.

Assoziationsregeln sind eine weitere Technik, die bei Maschinenlern-Algorithmen verwendet werden kann. Anders ausgedrückt, das Maschinenlern-Modell kann auf einer oder mehreren Assoziationsregeln basieren. Assoziationsregeln werden erstellt, indem Verhältnisse zwischen Variablen bei großen Datenmengen identifiziert werden. Der Maschinenlern-Algorithmus kann eine oder mehrere Verhältnisregeln identifizieren und/oder nutzen, die das Wissen darstellen, dass aus den Daten hergeleitet ist. Die Regeln können z. B. verwendet werden, um das Wissen zu speichern, zu manipulieren oder anzuwenden. Maschinenlern-Algorithmen basieren normalerweise auf einem Maschinenlern-Modell. Anders ausgedrückt, der Begriff "Maschinenlern-Algorithmus" kann einen Satz von Anweisungen bezeichnen, die verwendet werden können, um ein Maschinenlern-Modell zu erstellen, zu trainieren oder zu verwenden. Der Begriff "Maschinenlern-Modell" kann eine Datenstruktur und/oder einen Satz von Regeln bezeichnen, die/der das erlernte Wissen darstellt (z. B. basierend auf dem durch den Maschinenlern-Algorithmus ausgeführten Training). Bei Ausführungsbeispielen kann die Verwendung eines Maschinenlern-Algorithmus die Verwendung eines zugrundeliegenden Maschinenlern-Modells (oder einer Mehrzahl von zugrundeliegenden Maschinenlern-Modellen) implizieren. Die Verwendung eines Maschinenlern-Modells kann implizieren, dass das Maschinenlern-Modell und/oder die Datenstruktur/der Satz von Regeln, welche das Maschinenlern-Modell ist/sind, durch einen Maschinenlern-Algorithmus trainiert wird.

Beispielsweise kann das Maschinenlern-Modell ein künstliches neuronales Netz (ANN; artificial neural network) sein. ANNs sind Systeme, die durch biologische neuronale Netze inspiriert sind, wie sie in einer Netzhaut oder einem Gehirn zu finden sind. ANNs umfassen eine Mehrzahl von zwischenverbundenen Knoten und eine Mehrzahl von Verbindungen, sogenannte Kanten (edges), zwischen den Knoten. Es gibt normalerweise drei Knotentypen, Eingabeknoten, die Eingabewerte empfangen, versteckte Knoten, die (nur) mit anderen Knoten verbunden sind, und Ausgabeknoten, die Ausgabewerte bereitstellen. Jeder Knoten kann ein künstliches Neuron darstellen. Jede Kante kann Information senden, von einem Knoten zum anderen. Die Ausgabe eines Knoten kann als eine (nichtlineare) Funktion der Eingaben definiert sein (z.B. der Summe seiner Eingaben). Die Eingaben eines Knoten können in der Funktion basierend auf einem "Gewicht" der Kante oder des Knoten, der die Eingabe bereitstellt, verwendet werden. Das Gewicht von Knoten und/oder von Kanten kann in dem Lernprozess angepasst werden. Anders ausgedrückt, das Training eines künstlichen neuronalen Netzes kann ein Anpassen der Gewichte der Knoten und/oder Kanten des künstlichen neuronalen Netzes umfassen, d. h. um eine erwünschte Ausgabe für eine bestimmte Eingabe zu erreichen.

Alternativ kann das Maschinenlern-Modell eine Support-Vector-Machine, ein Random-Forest-Modell oder ein Gradient-Boosting-Modell sein. Support Vector Machines (d. h. Stützvektornetze) sind Supervised Learning-Modelle mit zugeordneten Lernalgorithmen, die verwendet werden können, um Daten zu analysieren (z. B. in einer Klassifizierungs- oder Regressionsanalyse). Support Vector Machines können durch Bereitstellen einer Eingabe mit einer Mehrzahl von Trainingseingabewerten, die zu einer von zwei Kategorien gehören, trainiert werden. Die Support Vector Machine kann trainiert werden, um einer der beiden Kategorien einen neuen Eingabewert zuzuweisen. Alternativ kann das Maschinenlern-Modell ein bayessches Netz sein, das ein probabilistisches gerichtetes azyklisches graphisches Modell ist. Ein bayessches Netz kann einen Satz von Zufallsvariablen und ihre bedingten Abhängigkeiten unter Verwendung eines gerichteten azyklischen Graphen darstellen. Alternativ kann das Maschinenlern-Modell auf einem genetischen Algorithmus basieren, der ein Suchalgorithmus und heuristische Technik ist, die den Prozess der natürlichen Selektion imitiert.

### Figurenliste

Die vorliegende Erfindung wird nachfolgend anhand der in den schematischen Figuren der Zeichnungen angegebenen Ausführungsbeispiele näher erläutert. Es zeigen dabei:
Fig. 1 eine schematische Darstellung einer LIDAR-Vermessung mittels eines Flugzeugs,

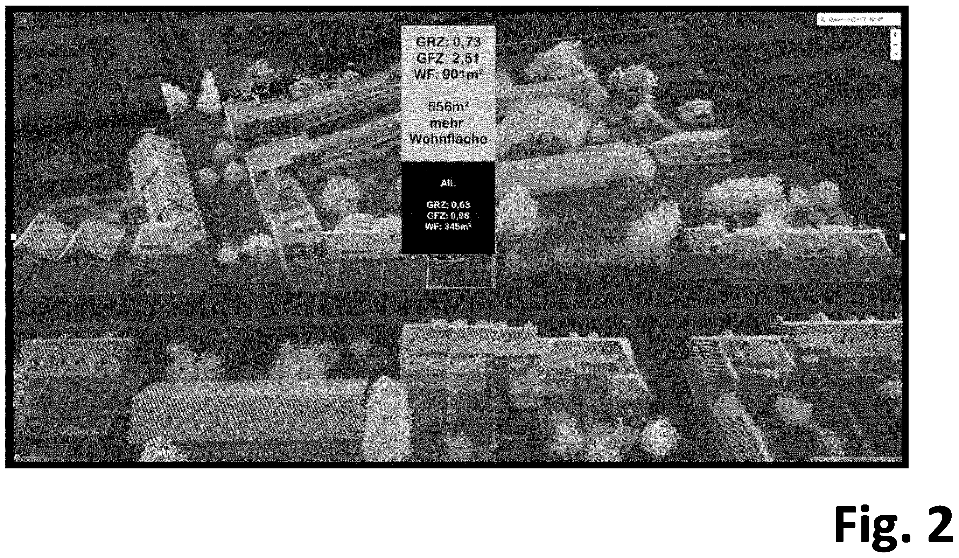

Fig. 2 eine schematische Darstellung einer Ausführungsform der vorliegenden Erfindung,
Fig. 3a-d ein beispielhaftes Grundstück mit Haus auf Basis von ALKIS- und LIDAR-Daten,
Fig. 4a-d ein zweites beispielhaftes Grundstück mit Haus auf Basis von ALKIS- und LIDAR-Daten,
Fig. 5 eine schematische Darstellung einer kleinen Siedlung zwecks Illustration der vorliegenden Erfindung,
Fig. 6 eine schematische Übersicht eines erfindungsgemäßen Datenflusses gemäß einer Ausführungsform der vorliegenden Erfindung,
Fig. 7 eine schematische Darstellung eines Deep Neuronal Networks zum Einsatz als Machine-Learning-Modell im Rahmen der vorliegenden Erfindung,
Fig. 8 eine schematische Darstellung eines Datenzusammenhanges und -flusses gemäß einer Ausführungsform der vorliegenden Erfindung.

In allen Figuren sind gleiche bzw. funktionsgleiche Elemente und Vorrichtungen - sofern nichts anderes angegeben ist - mit denselben Bezugszeichen versehen worden.

### Beschreibung der Zeichnungen

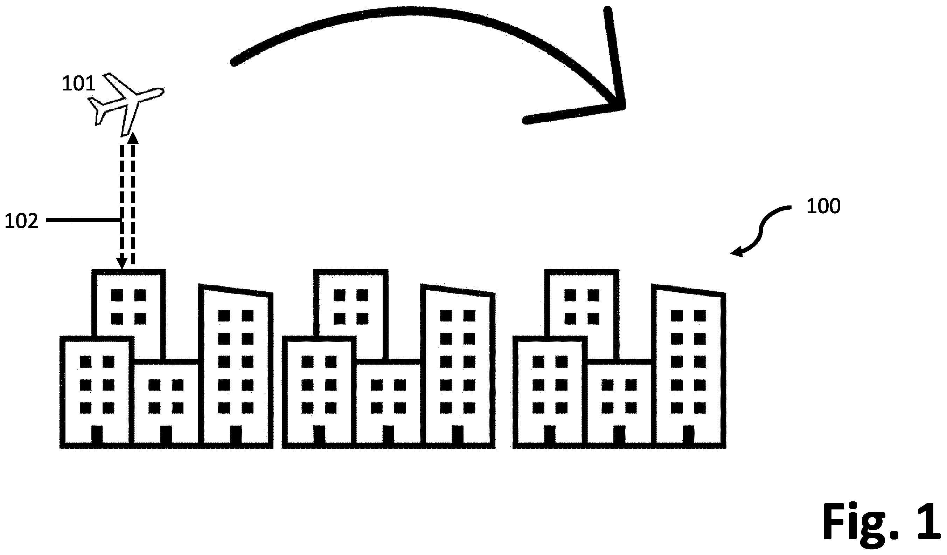

Die Figur 1 zeigt eine schematische Darstellung einer LIDAR-Vermessung eines physikalischen Systems 100, hier symbolisiert durch verschiedene Gebäude 100, welche auf einer Erdoberfläche angeordnet sind. Das Flugzeug 101 fliegt und trägt dabei eine LIDAR-Vermessungseinrichtung. Dabei sendet die LIDAR-Vermessungseinrichtung während des Fluges des Flugzeugs 101 Signale 102 aus, welche an den Gebäuden 100 bzw. an der dem Flugzeug zugewandten Oberfläche des physikalischen Systems 100 reflektiert werden.

Die Signale können im Allgemeinen in sämtlichen Richtungen emittiert und empfangen werden. Lediglich beispielhaft und schematisch wird das Signal 102 in der Figur als rechtwinklig zur Erdoberfläche dargestellt.

Durch entsprechende Rekonstruktionsalgorithmen kann eine rasteraufgelöste Karte ("LIDAR-Punktwolken") erstellt werden, welche die Oberfläche des physikalischen Systems zu reproduzieren ersucht.

Ein Pfeil deutet an, dass sich das Flugzeug während des Fluges fortbewegt. Die resultierende "LIDAR-Karte" wird so nach und nach erweitert.

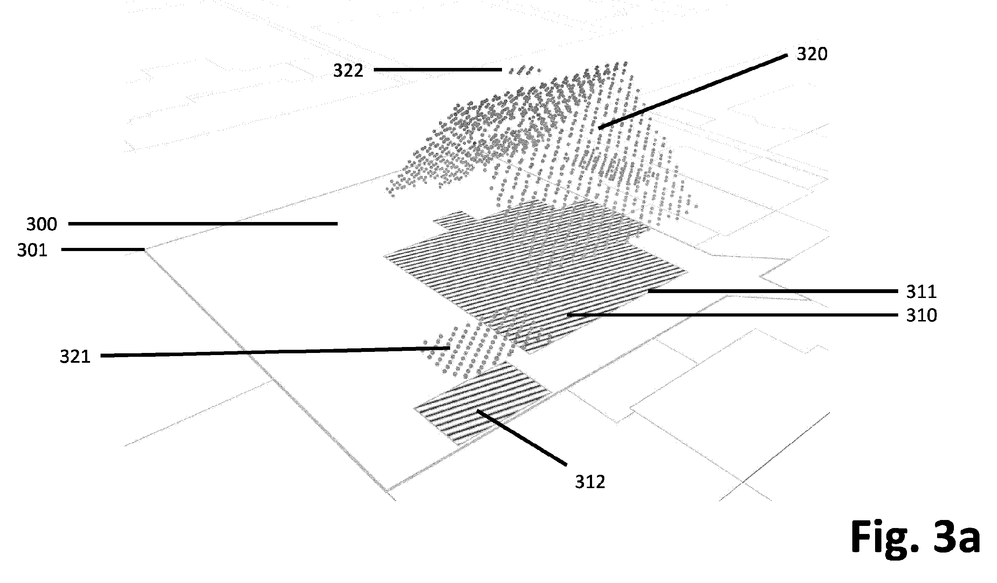

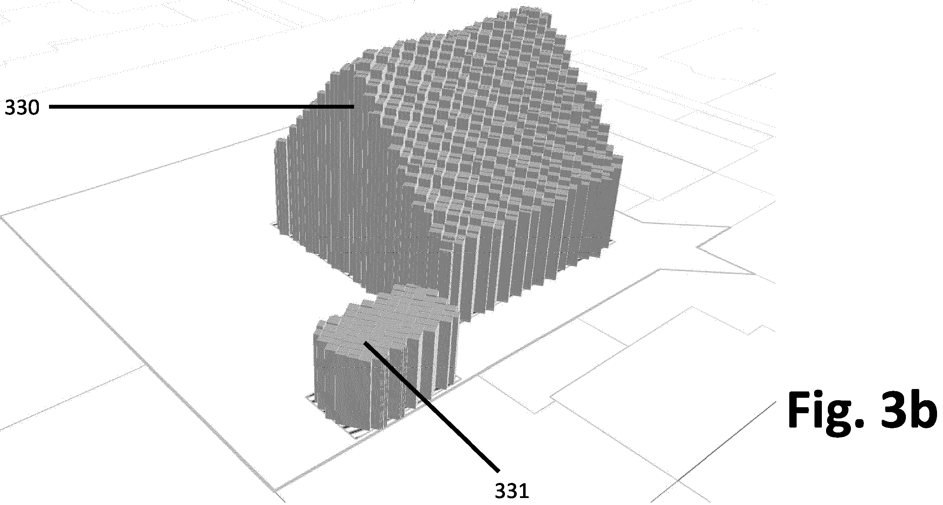

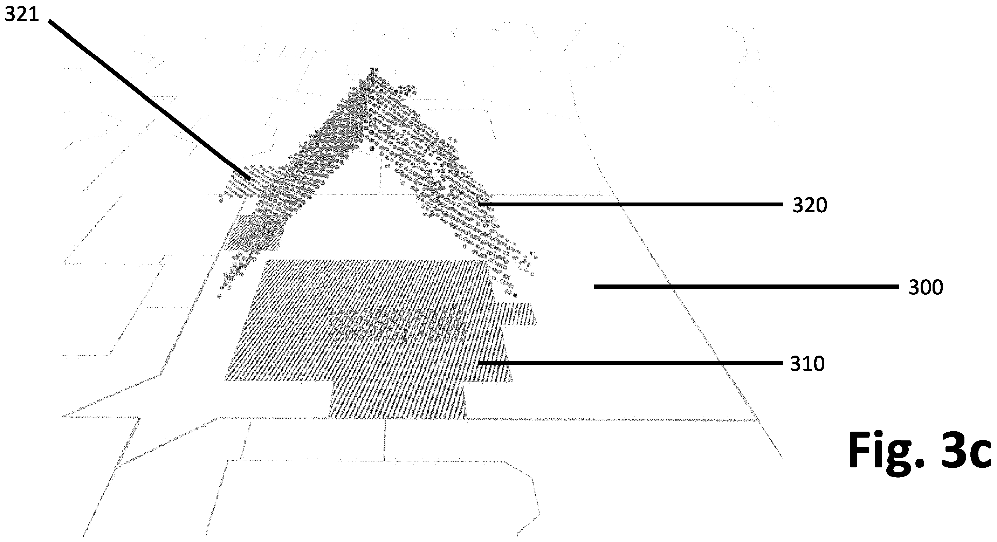

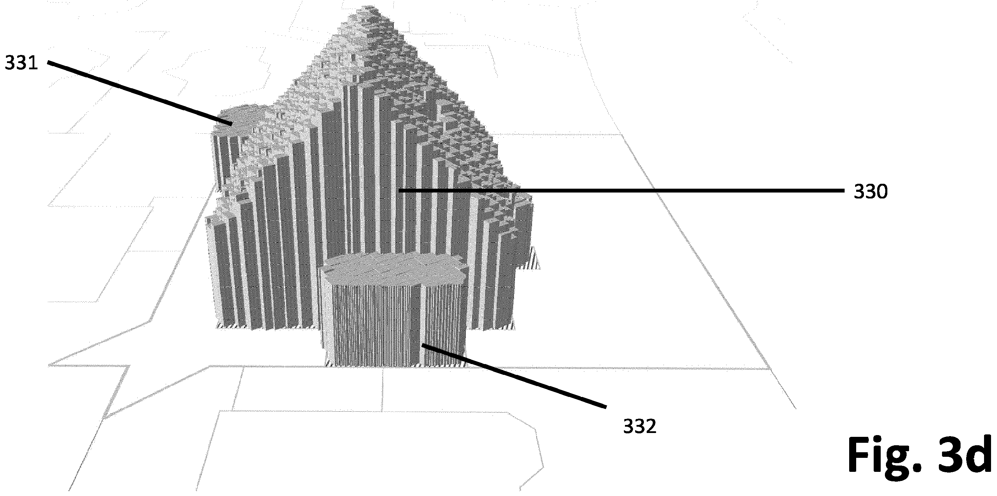

In den Figuren 3a und b ist ein Haus auf einem Grundstück zu sehen. Die Figuren 3c und d zeigen dies aus einer anderen Winkelperspektive.

Das Grundstück 100 ist durch einen Rand 301 definiert. Eine schraffierte Fläche 310 zeigt den Teil des Grundstücks auf, auf welchen ein Haus steht. Das Haus hat einen Rand 311 auf dem Grundstück. Es gibt zudem einen Bereich 312, in welchem sich eine Nebenanlage befindet. Diese Daten des Grundstücks und der baulichen Einrichtungen ergeben sich beispielsweise aus Daten eines amtlichen Liegenschaftskatasterinformationsssystems (ALKIS).

Es sind zudem LIDAR-Punktdaten 320, 321, 322 dargestellt. Die Daten 320 machen ein Dach des Hauses erkennbar, die Daten 322 einen hierauf angeordneten Schornstein. Die Daten 321 stellen das relativ flache Dach der Außenanlage (bspw. Garage) dar.

Bei den LIDAR-Daten handelt es sich um Verschnittpunktdaten im Sinne der Erfindung und ihrer Weiterbildungen. In dieser Ausführungsform wurden so LIDAR-Rohdaten im Bereich des Grundstückes 300 mit den bebauten Grundstücksteilen 310, 312 "verschnitten". Es sind also die LIDAR-Punkte dargestellt, welche sich oberhalb der bebauten Grundstücksteile 310, 312 befinden. In anderen Worten liegen beispielsweise die Punkte des Daches 320 bei einer Projektion in die Ebene des Grundstücks 300 innerhalb des Randes 311 des Hauses.

In der Figur 3b ist eine numerische Integration des Hauses und der Außenanlage graphisch dargestellt. Wie bereits detailliert beschrieben, kann mit einem solchen Verfahren beispielsweise das nutzbare Volumen und eine Geschossfläche (Floorspace) ausgerechnet werden. Auch anderen Bestimmungen, beispielsweise einer Bestimmung einer Zahl nutzbarer Geschosse, kann das hier dargestellte Säulenmodell zugrundegelegt werden. In der Figur 3d ist zusätzlich der Anbau 332 deutlich sichtbar dargestellt.

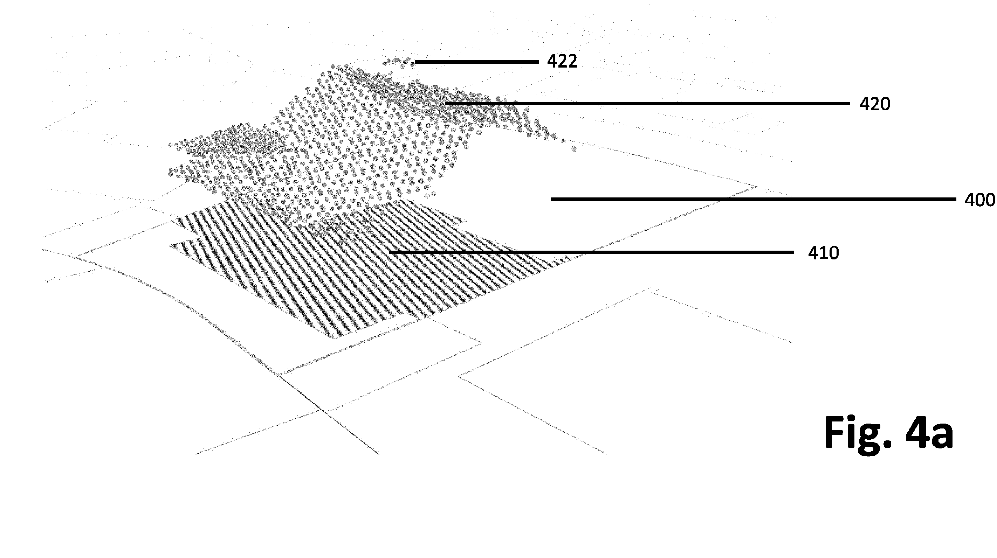

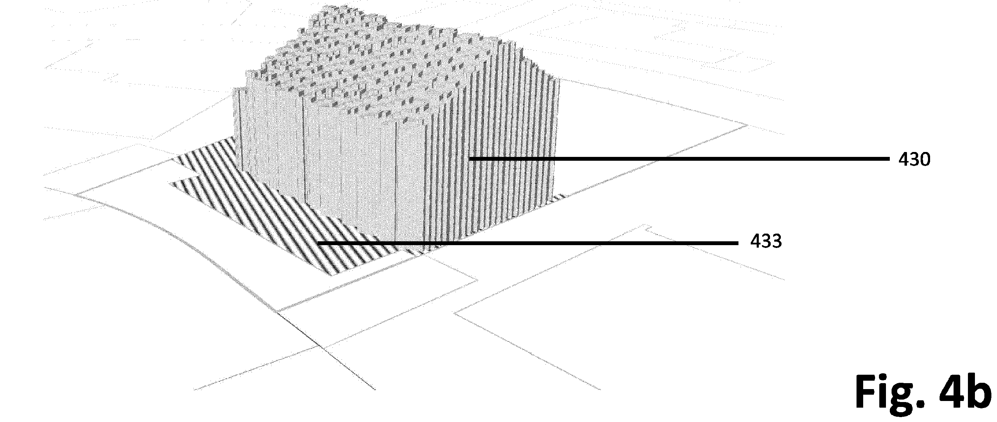

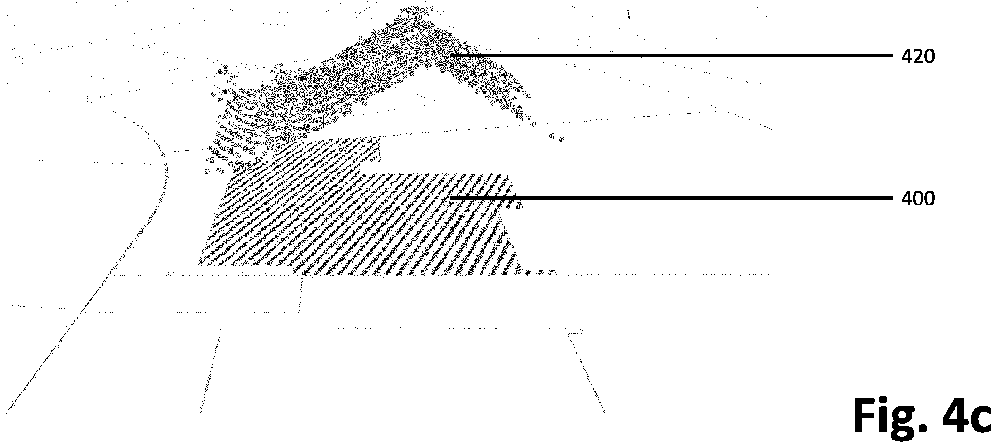

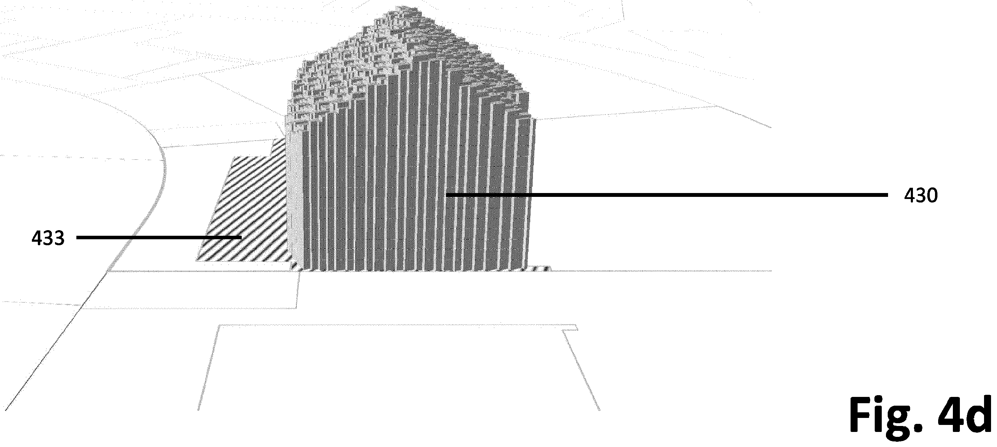

In den Figuren 4a-d ist analog ein zweites beispielhaftes Grundstück mit Haus auf Basis von ALKIS- und LIDAR-Daten zu sehen. Im vorliegenden Fall ist eine Nebenanlage 433 direkt an das Haus angebaut. Allein aus dem Dach 420 ist dieser Umstand nicht erkennbar. Durch die korrekte Auswertung von Sekundärdaten (hier: ALKIS-Daten) wird das Volumen des (Haupt-)Hauses 430 jedoch korrekt numerisch integriert (siehe insbesondere Fig. 4b und 4d). Auch andere relevante Größen werden im Rahmen der Erfindung korrekt bestimmt. Die Erfindung kann also auch einen solchen Fall korrekt bearbeiten, und wird hier nicht vom Dach "in die Irre geleitet", d.h. nicht zu falschen Schlussfolgerungen geführt.

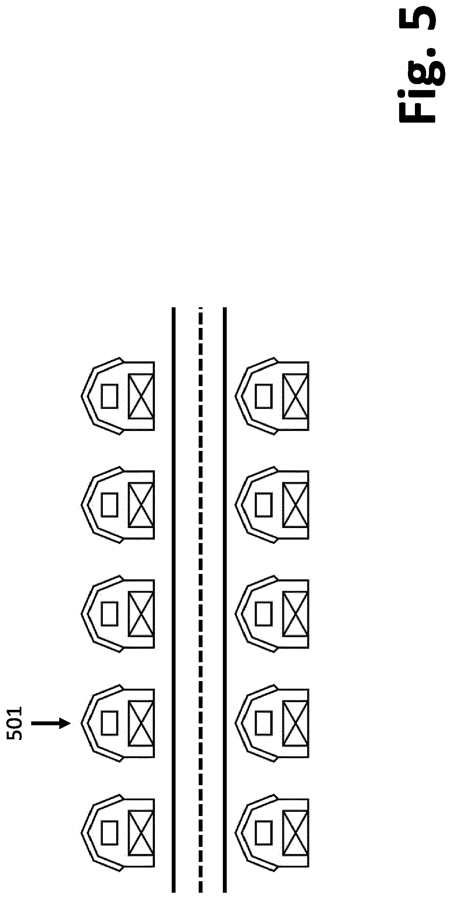

Die Figur 5 zeigt eine schematische Darstellung einer kleinen Siedlung zwecks Illustration der vorliegenden Erfindung. Schematisch liegen hier jeweils fünf Häuser auf gegenüberliegenden Seiten einer Straße. Die Häuser sind beispielsweise alle jeweils auf einem eigenen Grundstück angeordnet, wobei jedes Grundstück ein Flurstück umfasst.

Die Häuser mit Grundstück stellen Teilsysteme dar. Ein Teilsystem 501 ist ausgewählt. Die Erfindung vermag nun Verbesserungspotentiale in der dargestellten Siedlung erkennen und umsetzen.

In einem einfachen - schematischen - Beispiel mit dem ausgewählten Teilsystem 501 wird nun auf Basis der umliegenden Häuser eine Vorhersage gemacht, wie man das Grundstück des Teilsystems 501 bebauen bzw. besser nutzen könnte. Dies geschieht auf Basis der Eigenschaften des Grundstücks (Sekundärdaten des ausgewählten Teilsystems) sowie auf Basis der umliegenden neun Grundstücke samt ihrer Häuser (Teilsystemdaten der nichtausgewählten Teilsysteme). Auch Relationsdaten, welche die Relation des Teilsystems 501 zu den umliegenden neun Häusern und Grundstücken beschreiben, können beispielsweise berücksichtigt werden. In einem einfachen Beispiel wird berücksichtigt, dass die 10 Häuser alle an derselben Straße liegen. In einem weiteren Beispiel wird berücksichtigt, dass vier Häuser an der gleichen Seite der Straße liegen und/oder, dass fünf Häuser an der anderen Straßenseite liegen. Eine Wertung, "wie" relevant nun die Eigenschaften der vier Häuser bspw. im Vergleich zu Eigenschaften der fünf Häuser sind, wird durch die vorliegende Erfindung geleistet, insbesondere durch den Einsatz von Machine Learning (auf Basis von Training des Machine-Learning-Modells).

In einem Beispiel wird dabei zudem das bereits existente Haus des Teilsystems 501 außer Betracht gelassen. Es wird als Variable im Rahmen der Systemverbesserung betrachtet. Als Ergebnis könnte ein solches Haus jedoch verändert, aufgestockt oder neugebaut werden.

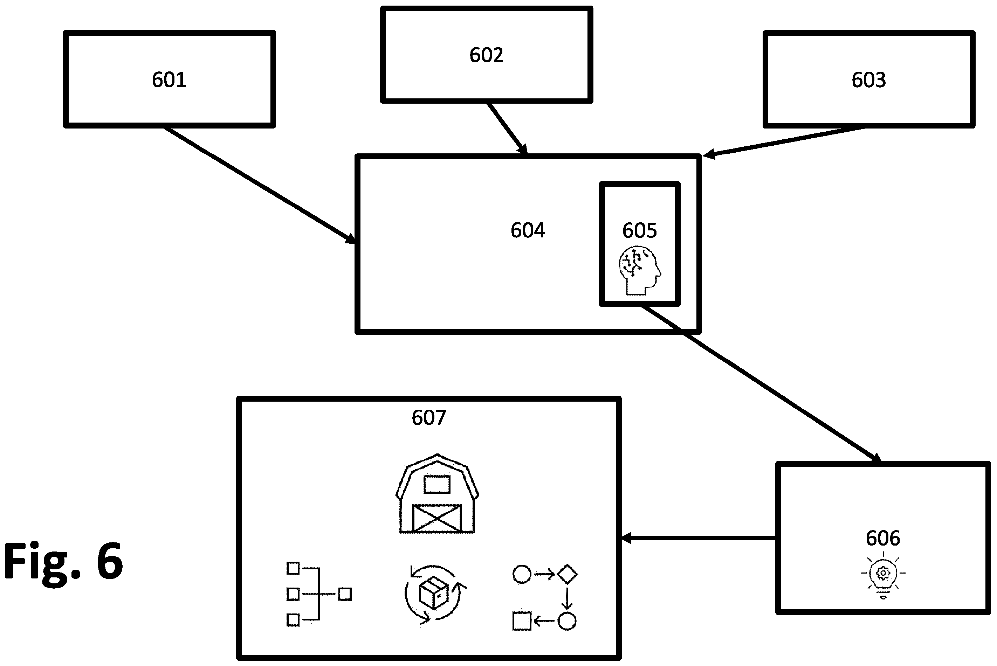

Die Figur 6 zeigt eine schematische Übersicht eines erfindungsgemäßen Datenflusses gemäß einer Ausführungsform der vorliegenden Erfindung. In eine Analyse 604 mit Machine-Learning-Modell 605 fließen LIDAR- bzw. 3D-Modell-Daten/LoD-Daten 601, ALKIS-Daten 602 sowie Photogrammetriedaten 603 ein. Durch die Kombination dieser Datenquellen kann die Erfindungen Synergien zwischen den Datensätzen gewinnbringend nutzen und auswerten. Für ein oder mehrere ausgewählte Teilsysteme wird ein Vorschlag bzw. eine Vorhersage 606 ausgegeben, welche(r) sodann in der Realität umgesetzt wird. Beispielsweise wird ein Gebäude gebaut, aufgestockt oder angepasst, oder es wird ein Prozess angepasst, oder es wird beispielsweise ein Schaltkreis(element) oder ein Qubit modifiziert.

Der dargestellt Datenfluss kann als Regel- und/oder Steuerkreis für das physikalische System betrachtet werden.

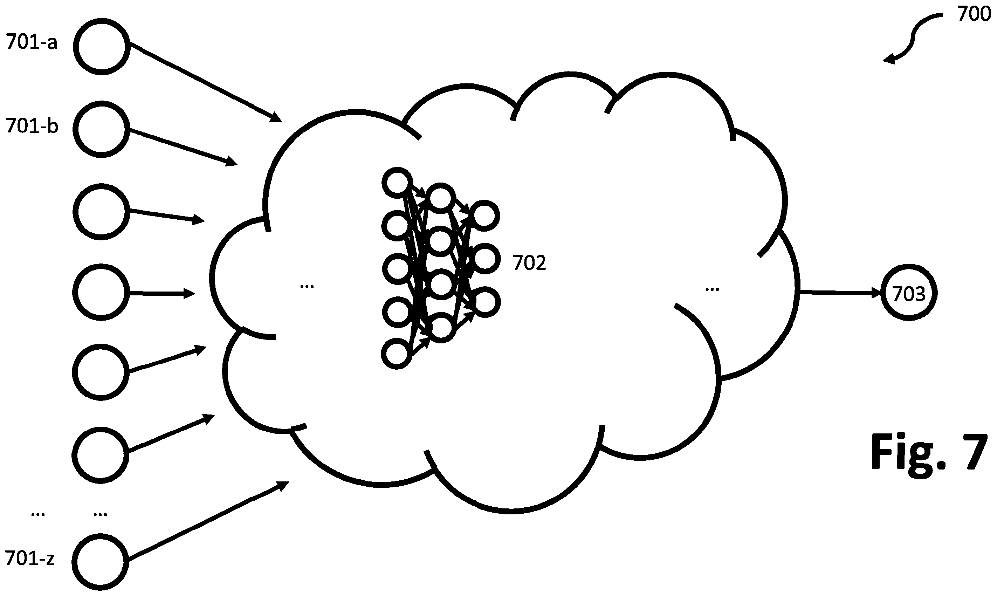

Die Figur 7 zeigt eine schematische Darstellung eines Deep Neural Networks zum Einsatz als Machine-Learning-Modell im Rahmen der vorliegenden Erfindung. Das Deep Neural Network (Künstliches Neuronales Netz) verfügt über mindestens ein Eingangsneuron 701, in der Regel mehrere, insbesondere zahlreiche (die Bezeichnung 701a-z ist lediglich symbolisch und limitiert eine Anzahl keineswegs). Es gibt mindestens ein Ausgangsneuron 703. Hierzwischen können verschiedene Strukturen angeordnet sein, insbesondere ein oder mehrere Hidden Layers 702.

An den Eingangsneuronen 701a-z können beispielsweise Sekundärdaten eines ausgewählten Teilsystems und Teilsystemdaten von nicht-ausgewählten Teilsystemen, aber auch beispielsweise Relationsdaten zwischen ausgewählten und nicht-ausgewählten Teilsystemen eingegeben werden.

An dem Ausgangsneuron 703 wird beispielsweise eine Vorhersage verfügbar gemacht, wie man ein ausgewähltes Teilsystem modifizieren oder neu bebauen könnte.

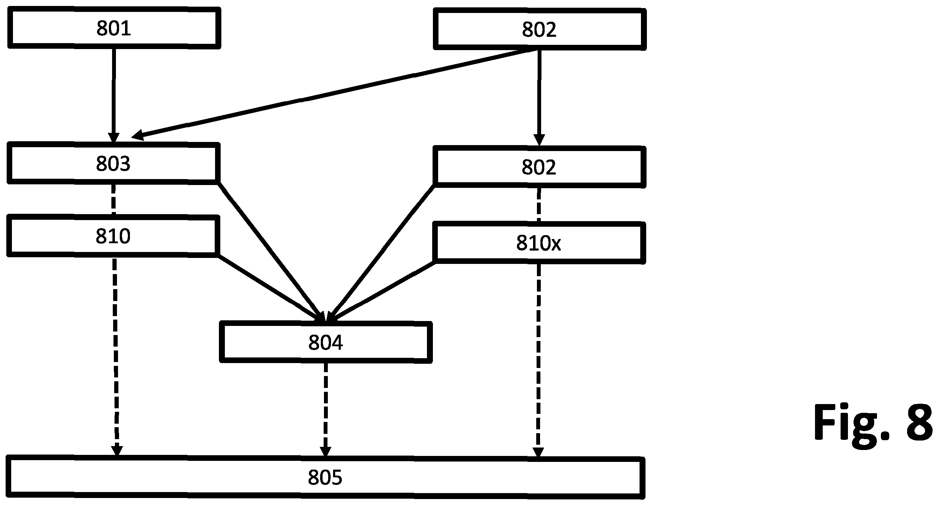

Die Figur 8 zeigt eine schematische Darstellung eines Datenzusammenhanges und -flusses gemäß einer Ausführungsform der vorliegenden Erfindung. Hierzu wird auf den allgemeinen Teil des Erfindungsdiskussion verwiesen.

Die Teilsystemdaten 803 können die Sekundärdaten und die LIDAR/LoD-Daten 801 umfassen und/oder hieraus abgeleitet werden. Eine Vorhersage 805 wird durch ein Machine-Learning-Modell möglich gemacht. Die Sekundärdaten 802 werden für das ausgewählte Teilsystem 810x berücksichtigt. Die Teilsystemdaten 803 werden insbesondere für nicht-ausgewählte Teilsysteme 810 berücksichtigt. Zudem können Relationsdaten 804 geschaffen bzw. hergeleitet und sukzessive berücksichtigt werden.

### Bezugszeichenliste

- 100: Physikalisches System
- 101: Flugzeug
- 102: Messsignal
- 300: Grundstück (hier identisch mit Flurstück)
- 301: Rand des Grundstücks (Rand des Flurstücks)
- 310: Bebauter Grundstückteil (Haus)
- 311: Rand des bebauten Grundstückteils (i.e. des Hauses)
- 312: Bebauter Grundstückteil (Außenanlage)
- 320: Dach eines Hauses / "Punktwolke" der Verschnittpunktdaten
- 321: Dach einer Nebenanlage / "Punktwolke" der Verschnittpunktdaten
- 322: Schonstein/Kamin
- 330: Numerisch integriertes Haus / Volumen
- 331: Numerisch integrierte Nebenanlage / Volumen
- 332: Numerisch integrierter Anbau / Volumen
- 400: Grundstück (hier identisch mit Flurstück)
- 410: Bebauter Grundstückteil (Haus)
- 420: Dach eines Hauses / "Punktwolke" der Verschnittpunktdaten (hier dargestellt einschließlich Nebenanlage)
- 422: Schonstein/Kamin
- 430: Numerisch integriertes Haus / Volumen (hier ohne direkt am Haus gelegene Nebenanlage)
- 433: Bebauter Grundstückteil (hier jedoch zur Nebenanlage gehörig)
- 501: ausgewähltes Teilsystem / ausgewähltes Grundstück oder Gebäude
- 601: LIDAR/LoD-Daten
- 602: ALKIS-Daten
- 603: Photogrammetriedaten
- 604: Analyse
- 605: Machine-Learning-Modell, insbesondere Künstliches Neuronales Netz
- 606: Vorschlag/Vorhersage
- 607: Umsetzung (Bau eines Gebäudes, Anpassung eines Prozesses, Anpassung eines Schaltkreises, Modifikation eines Qubits etc.)
- 700: Künstliches Neuronales Netz (schematisch)
- 701-(a-z): beispielhafte Eingangsneuronen
- 702: beispielhafte Hidden Layers (schematisch)
- 703: beispielhafte Ausgangsneuron
- 801: LIDAR/LoD-Daten
- 802: Sekundärdaten
- 803: Teilsystemdaten
- 804: Relationsdaten
- 805: Vorhersage/Potential/Ergebnis
- 810: nicht-ausgewählte Teilsysteme
- 810x: ausgewählte(s) Teilsystem(e) (x bezeichnet ausgewählt)

## Patentansprüche

1. Computerimplementiertes Verfahren zum Bestimmen eines Bodenreferenzpunktes, umfassend die folgenden Schritte:
- Identifizieren eines physikalischen Systems (100) in einem dreidimensionalen Raum,
- Bereitstellen von dreidimensionalen LIDAR-Daten (601, 801) in dem dreidimensionalen Raum,
- Identifizieren eines zweidimensionalen Raumes, welcher zu einer datentechnischen Beschreibung einer zweidimensionalen Projektion des physikalischen Systems (100) in dem dreidimensionalen Raum geeignet ist, insbesondere zu einer zweidimensionalen Projektion der LIDAR-Daten (601, 801)
- Bereitstellen von Photogrammetriedaten (603), welche sich auf den dreidimensionalen Raum beziehen
- Erkennen mindestens einer versiegelten Fläche und ihrer Abmaße in dem
zweidimensionalen Raum auf Basis der Photogrammetriedaten (603) **gekennzeichnet durch**:
- Bestimmen eines Bodenreferenzpunktes durch Erkennen eines Objektes in den Photogrammetriedaten, welches dazu geeignet ist, als Bodenreferenzpunkt zu dienen, insbesondere Schacht- und Kanaldeckel,
- Verschneiden der Ausmaße des erkannten Objektes mit den dreidimensionalen Punktdaten zur Erzeugung von Verschnittpunktdaten
- Bilden eines Durchschnittes der Verschnittpunktdaten zur Bestimmung des Bodenreferenzpunktes.

2. Verfahren nach Anspruch 1, ferner umfassend einen Schritt eines Messens mindestens eines Punktdatums mittels einer LIDAR-Messvorrichtung, insbesondere durch eine flugfähige LIDAR-Messvorrichtung (101).

3. Verfahren nach Anspruch 1 oder 2, ferner umfassend ein Bereitstellen von Sekundärdaten umfassend zweidimensionale Polygondaten, insbesondere eines Katasters.

4. Verfahren nach einem der vorhergehenden Ansprüche, ferner umfassend einen Schritt eines Klassifizierens und Markierens von Punkten als Dachpunkte auf Basis eines zweiten Machine-Learning-Modells, insbesondere zweiten Künstlichen Neuronalen Netzes.

5. Verfahren nach Anspruch 4, wobei das zweite Machine-Learning-Modell trainiert wird und/oder wurde durch ein Verfahren umfassend einen Schritt eines Verschneidens von dreidimensionalen Punktdaten mit einem durch Sekundärdaten definierten Gebäudeteil eines Teilsystems des physikalischen Systems zur Erzeugung von Verschnittpunktdaten.

6. Verfahren nach einem der vorhergehenden Ansprüche, wobei ferner auf der Menge der Verschnittpunktdaten eine Klassifikation und Markierung von Punkten als Dachpunkte stattfindet, insbesondere ein Clustering und/oder durch unüberwachtes Lernen, insbesondere auf Basis des euklidischen Abstandes der Punkte zueinander als relevantes Maß und/oder auf Basis des Vertikalabstandes, insbesondere der Vertikal- bzw. z-Komponente, der Punkte zueinander als relevantes Maß, und/oder auf Basis von Normalenvektoren.

7. Verfahren nach einem der Ansprüche 3 - 6, ferner umfassend einen Schritt eines Verschneidens von dreidimensionalen Punktdaten mit einem durch die Sekundärdaten definierten Gebäudeteil eines Teilsystems des physikalischen Systems zur Erzeugung von Verschnittpunktdaten sowie einen Schritt eines Markierens der Punkte der Verschnittpunktdaten, welche in den Bereich des Gebäudeteils fallen, in den dreidimensionalen Punktdaten.

8. Verfahren nach einem der vorhergehenden Ansprüche, ferner umfassend ein Nutzen eines Machine-Learning-Modells eines überwachten Lernens, insbesondere eines Künstlichen Neuronalen Netzes und/oder einer linearen Regression, zum Vorhersagen von Eigenschaften eines ausgewählten Teilsystems des physikalischen Systems.

9. Verfahren nach Anspruch 8, ferner umfassend einen Schritt eines Anpassens des physikalischen Systems durch Veränderung des ausgewählten Teilsystems, in der vom Machine-Learning-Modell, insbesondere vom Künstlichen Neuronalen Netz, vorgeschlagenen Form, insbesondere durch Bau, Umbau oder Neubau einer oder mehrerer Gebäudestrukturen im ausgewählten Teilsystem.

10. Verfahren nach einem der vorhergehenden Ansprüche, ferner umfassend einen Schritt eines Clusterings von Teilsystemen des physikalischen Systems zu zusammengehörigen Clustern und entsprechendes Markieren der Teilsysteme in Bezug auf ihre Clusterzugehörigkeit, insbesondere unter Nutzung einer Kl-Technik eines unüberwachten Lernens.

11. Verfahren nach einem der vorhergehenden Ansprüche, wobei Daten zu Teilsystemen des physikalischen Systems eines oder mehrere umfassen aus:
- Firsthöhe, Traufhöhe, Höhe eines Daches, Dachwinkel, Grundflächenzahl GRZ, Grundflächenzahl GRZ1, Grundflächenzahl GRZ2, Geschossflächenzahl GFZ, Geschossfläche, Volumen, Anzahl nutzbarer Geschosse, Anzahl der Vollgeschosse
- Vorhandensein und Ausmaß versiegelter Flächen
- Bodenreferenzpunkt
- Region, Stadt und/oder Kreis, in dem/der sich das Teilsystem befindet
- Maß der baulichen Nutzung eines nächsten Nachbarn
- Maß der baulichen Nutzung eines m-nächsten (zweitnächsten, drittnächsten, etc.) Nachbarn
- eine Boolesche Aussage dazu, ob der nächste Nachbar an einer selben Verbindung, insbesondere einer selben Straße, lokalisiert ist wie das ausgewählte Teilsystem
- eine Boolesche Aussage dazu, ob der m-nächste Nachbar an einer selben Verbindung, insbesondere einer selben Straße, lokalisiert ist wie das ausgewählte Teilsystem
- eine Boolesche Aussage dazu, ob der nächste Nachbar eine offene oder geschlossene Bauweise hat
- eine Boolesche Aussage dazu, ob der m-nächste Nachbar eine offene oder geschlossene Bauweise hat
- eine Boolesche Aussage dazu, ob der nächste Nachbar ein Gebäude im Hof oder an der Straße aufweist
- eine Boolesche Aussage dazu, ob der m-nächste Nachbar ein Gebäude im Hof oder an der Straße aufweist
- eine Längenangabe, welche eine Entfernung des Gebäudes des nächsten Nachbarn zur Straße bestimmt
- eine Längen- und/oder Tiefenangabe, welche bestimmt, wie tief ein Haus grundstückeinwärts in Bezug auf die Straße gebaut ist
- Einschlägiges Baugebiet
- Einschlägige Bebauungspläne
- Nutzungsvorschriften nach gesetzlichen Vorgaben, insbesondere Baunutzungsverordnung
- Clusterzugehörigkeit des Teilsystems zu einem Cluster von Teilsystemen.

12. Verfahren nach einem der Ansprüche 8 - 11, wobei der Schritt des Nutzens des Machine-Learning-Modells, insbesondere des Künstlichen Neuronalen Netzes, ferner geschieht auf Basis von Relationsdaten, welche mindestens eine Eigenschaft umfassen, die eine Relation zwischen dem ausgewählten Teilsystem und anderen Teilsystemen, insbesondere nichtausgewählten Teilsystemen, beschreibt.

13. Verfahren nach einem der vorhergehenden Ansprüche, ferner umfassend einen Schritt eines Erzeugens von LoD-Daten auf Basis der dreidimensionalen Punktdaten, insbesondere LIDAR-Daten.

14. Verfahren nach Anspruch 13, wobei Daten zu Teilsystemen des physikalischen Systems auf Basis der erzeugten LoD-Daten erzeugt werden und/oder wurden.

15. Computer, Computerprogramm, Computernetzwerk oder computerlesbarer Datenträger, welche dazu eingerichtet sind, das Verfahren nach einem der vorhergehenden Ansprüche 1 oder 3 - 14 zu bewirken, oder
Computer, Computerprogramm, Computernetzwerk oder computerlesbarer Datenträger, welche dazu eingerichtet sind, das Verfahren nach Anspruch 2 zu bewirken, umfassend mindestens einen Befehl, welcher dazu geeignet ist, zu bewirken, dass eine LIDAR-Messvorrichtung den Schritt eines Messens mindestens eines Punktdatums vollzieht.

## Claims

1. A computer-implemented method for determining a ground reference point, comprising the following steps:
- identifying a physical system (100) in a three-dimensional space,
- providing three-dimensional LIDAR data (601, 801) in the three-dimensional space,
- identifying a two-dimensional space suitable for a digital description of a two-dimensional projection of the physical system (100) in the three-dimensional space, in particular a two-dimensional projection of the LIDAR data (601, 801)
- providing photogrammetric data (603) relating to the three-dimensional space
- Detecting at least one sealed surface and its dimensions in the two-dimensional space based on the photogrammetric data (603)
**characterized by**
- determining a ground reference point by detecting an object in the photogrammetric data that is suitable for serving as a ground reference point, in particular manhole and sewer covers;
- intersecting the dimensions of the detected object with the three-dimensional point data to generate intersection point data
- calculating an average of the intersection point data to determine the ground reference point.

2. A method according to claim 1, further comprising a step of measuring at least one point datum using a LIDAR measuring device, in particular an airborne LIDAR measuring device (101).

3. A method according to claim 1 or 2, further comprising providing secondary data comprising two-dimensional polygon data, in particular from a cadastral survey.

4. A method according to any of the preceding claims, further comprising a step of classifying and marking points as roof points based on a second machine learning model, in particular a second artificial neural network.

5. A method according to claim 4, wherein the second machine-learning model is trained and/or was trained by a method comprising a step of intersecting three-dimensional point data with a building component of a subsystem of the physical system defined by secondary data to generate intersection point data.

6. A method according to any one of the preceding claims, wherein, furthermore, the points are classified and marked as roof points based on the set of intersection point data, in particular by clustering and/or through unsupervised learning, in particular based on the Euclidean distance between the points as a relevant measure and/or based on the vertical distance, in particular the vertical or z-component, of the points relative to one another as a relevant measure, and/or based on normal vectors.

7. A method according to any one of claims 3-6, further comprising a step of intersecting three-dimensional point data with a building component of a subsystem of the physical system defined by the secondary data to generate intersection point data, as well as a step of marking the points of the intersection point data that fall within the area of the building component in the three-dimensional point data.

8. A method according to any of the preceding claims, further comprising the use of a supervised machine learning model, in particular an artificial neural network and/or linear regression, to predict characteristics of a selected subsystem of the physical system.

9. A method according to claim 8, further comprising a step of adapting the physical system by modifying the selected subsystem in the manner proposed by the machine learning model, in particular the artificial neural network, specifically by constructing, renovating, or rebuilding one or more building structures within the selected subsystem.

10. A method according to any of the preceding claims, further comprising a step of clustering subsystems of the physical system into related clusters and correspondingly labeling the subsystems with respect to their cluster membership, in particular using an AI technique of unsupervised learning.

11. A method according to any of the preceding claims, wherein data relating to subsystems of the physical system comprises one or more of the following:
- ridge height, eave height, roof height, roof pitch, floor area ratio GRZ, floor area ratio GRZ1, floor area ratio GRZ2, floor space index GFZ, floor area, volume, number of usable stories, number of full stories
- Presence and extent of impervious surfaces
- ground reference point
- Region, city, and/or county in which the subsystem is located
- Extent of building use by the nearest neighbor
- Extent of built-up area of an m-nearest (second-nearest, third-nearest, etc.) neighbor
- A Boolean statement indicating whether the nearest neighbor is located on the same route, specifically the same street, as the selected subsystem
- A Boolean statement indicating whether the m-next neighbor is located on the same route-specifically, the same street-as the selected subsystem
- A Boolean statement indicating whether the next neighbor has an open or closed structure
- a Boolean statement indicating whether the m-th nearest neighbor has an open or closed design
- a Boolean statement indicating whether the next neighbor has a building in the courtyard or on the street
- a Boolean statement indicating whether the m-next neighbor has a building in the courtyard or on the street
- a length specification that determines the distance of the nearest neighbor's building from the street
- a length and/or depth value that determines how far a house is set back from the street
- Relevant Development Area
- Applicable zoning plans
- Land use regulations in accordance with legal requirements, in particular the Building Land Use Ordinance
- Cluster affiliation of the subsystem to a cluster of subsystems.

12. A method according to any one of claims 8-11, wherein the step of using the machine learning model, in particular the artificial neural network, is further based on relational data comprising at least one property that describes a relationship between the selected subsystem and other subsystems, in particular non-selected subsystems.

13. A method according to any of the preceding claims, further comprising a step of generating LoD data based on the three-dimensional point data, in particular LIDAR data.

14. A method according to claim 13, wherein data relating to subsystems of the physical system is generated and/or has been generated based on the generated LoD data.

15. A computer, computer program, computer network, or computer-readable medium configured to carry out the method according to any of the preceding claims 1 or 3-14, or
a computer, computer program, computer network, or computer-readable medium configured to carry out the method according to claim 2, comprising at least one instruction suitable for causing a LIDAR measuring device to perform the step of measuring at least one point data.

## Revendications

1. Procédé mis en œuvre par ordinateur pour déterminer un point de référence au sol, comprenant les étapes suivantes :
- l'identification d'un système physique (100) dans un espace tridimensionnel,
- la mise à disposition de données LIDAR tridimensionnelles (601, 801) dans l'espace tridimensionnel,
- l'identification d'un espace bidimensionnel adapté à une description informatique d'une projection bidimensionnelle du système physique (100) dans l'espace tridimensionnel, en particulier d'une projection bidimensionnelle des données LIDAR (601, 801)
- fournir des données photogrammétriques (603) se rapportant à l'espace tridimensionnel
- Détection d'au moins une surface scellée et de ses dimensions dans l'espace bidimensionnel sur la base des données photogrammétriques (603) **caractérisé par**
- la détermination d'un point de référence au sol par la détection, dans les données photogrammétriques, d'un objet apte à servir de point de référence au sol, notamment des couvercles de regards et de canalisations,
- l'intersection des dimensions de l'objet détecté avec les données de points tridimensionnelles pour générer des données de points d'intersection
- le calcul d'une moyenne des données de points d'intersection pour déterminer le point de référence au sol.

2. Procédé selon la revendication 1, comprenant en outre une étape consistant à mesurer au moins un point de référence à l'aide d'un dispositif de mesure LIDAR, notamment à l'aide d'un dispositif de mesure LIDAR aéroporté (101).

3. Procédé selon la revendication 1 ou 2, comprenant en outre une étape consistant à fournir des données secondaires comprenant des données polygonales bidimensionnelles, notamment issues d'un cadastre.

4. Procédé selon l'une des revendications précédentes, comprenant en outre une étape consistant à classer et à marquer des points en tant que points de toiture sur la base d'un deuxième modèle d'apprentissage automatique, en particulier d'un deuxième réseau neuronal artificiel.

5. Procédé selon la revendication 4, dans lequel le deuxième modèle d'apprentissage automatique est et/ou a été entraîné par un procédé comprenant une étape consistant à croiser des données de points tridimensionnelles avec une partie de bâtiment d'un sous-système du système physique, définie par des données secondaires, afin de générer des données de points d'intersection.

6. Procédé selon l'une des revendications précédentes, dans lequel, en outre, une classification et un marquage des points en tant que points de toiture sont effectués sur l'ensemble des données de points d'intersection, notamment par regroupement (clustering) et/ou par apprentissage non supervisé, en particulier sur la base de la distance euclidienne entre les points comme mesure pertinente et/ou sur la base de la distance verticale, notamment de la composante verticale ou z, des points les uns par rapport aux autres en tant que mesure pertinente, et/ou sur la base de vecteurs normaux.

7. Procédé selon l'une des revendications 3 à 6, comprenant en outre une étape consistant à croiser des données de points tridimensionnelles avec une partie de bâtiment d'un sous-système du système physique, définie par les données secondaires , afin de générer des données de points d'intersection, ainsi qu'une étape consistant à marquer, dans les données de points tridimensionnelles, les points des données de points d'intersection qui se trouvent dans la zone de la partie de bâtiment.

8. Procédé selon l'une des revendications précédentes, comprenant en outre l'utilisation d'un modèle d'apprentissage automatique de type « apprentissage supervisé », en particulier d'un réseau neuronal artificiel et/ou d'une régression linéaire, pour prédire les propriétés d'un sous-système sélectionné du système physique.

9. Procédé selon la revendication 8, comprenant en outre une étape consistant à adapter le système physique en modifiant le sous-système sélectionné, sous la forme proposée par le modèle d'apprentissage automatique, en particulier par le réseau neuronal artificiel, notamment par la construction, la transformation ou la reconstruction d'une ou plusieurs structures de bâtiment dans le sous-système sélectionné.

10. Procédé selon l'une des revendications précédentes, comprenant en outre une étape de regroupement en grappes de sous-systèmes du système physique en grappes apparentées et le marquage correspondant des sous-systèmes en fonction de leur appartenance à une grappe, notamment en utilisant une technique d'IA d'apprentissage non supervisé.

11. Procédé selon l'une des revendications précédentes, dans lequel les données relatives aux sous-systèmes du système physique comprennent un ou plusieurs des éléments suivants :
- hauteur de faîte, hauteur de gouttière, hauteur d'un toit, pente du toit, coefficient d'occupation des sols GRZ, coefficient d'occupation des sols GRZ1, coefficient d'occupation des sols GRZ2, coefficient d'occupation des étages GFZ, surface de plancher, volume, nombre d'étages utilisables, nombre d'étages complets
- présence et étendue des surfaces imperméabilisées
- point de référence au sol
- région, ville et/ou canton dans lequel se trouve le sous-système
- Degré d'occupation par des constructions chez un voisin le plus proche
- Degré d'occupation par des constructions d'un voisin m-ième (deuxième, troisième, etc.)
- une affirmation booléenne indiquant si le voisin le plus proche est situé sur une même voie, en particulier une même rue, que le sous-système sélectionné
- une déclaration booléenne indiquant si le m-ième voisin le plus proche est situé sur la même voie, en particulier la même rue, que le sous-système sélectionné
- une proposition booléenne indiquant si le voisin le plus proche présente une construction ouverte ou fermée
- une proposition booléenne indiquant si le m-ième voisin le plus proche présente une construction ouverte ou fermée
- une proposition booléenne indiquant si le voisin le plus proche comporte un bâtiment dans la cour ou donnant sur la rue
- une affirmation booléenne indiquant si le m-ième voisin immédiat comporte un bâtiment donnant sur la cour ou sur la rue
- une indication de longueur qui détermine la distance entre le bâtiment du voisin le plus proche et la rue
- une indication de longueur et/ou de profondeur qui détermine à quelle profondeur une maison est construite à l'intérieur de la parcelle par rapport à la rue
- Zone d'aménagement concernée
- Plans d'urbanisme applicables
- Règles d'utilisation conformément aux dispositions légales, en particulier le règlement sur l'utilisation des sols
- Appartenance du sous-système à un cluster de sous-systèmes.

12. Procédé selon l'une des revendications 8 à 11, dans lequel l'étape consistant à utiliser le modèle d'apprentissage automatique, en particulier le réseau neuronal artificiel, s'effectue en outre sur la base de données relationnelles comprenant au moins une propriété décrivant une relation entre le sous-système sélectionné et d'autres sous-systèmes, en particulier des sous-systèmes non sélectionnés.

13. Procédé selon l'une des revendications précédentes, comprenant en outre une étape de génération de données LoD sur la base des données de points tridimensionnelles, en particulier des données LIDAR.

14. Procédé selon la revendication 13, dans lequel des données relatives aux sous-systèmes du système physique sont générées et/ou ont été générées sur la base des données LoD générées.

15. Ordinateur, programme informatique, réseau informatique ou support de données lisible par ordinateur, conçus pour mettre en œuvre le procédé selon l'une des revendications précédentes 1 ou 3 à 14, ou
ordinateur, programme informatique, réseau informatique ou support de données lisible par ordinateur, conçus pour mettre en œuvre le procédé selon la revendication 2, comprenant au moins une instruction apte à amener un dispositif de mesure LIDAR à effectuer l'étape consistant à mesurer au moins un point de référence.
